# EUROPÄISCHE PATENTANMELDUNG

(11) **EP 2 348 639 A2**
(43) Veröffentlichungstag der Anmeldung: **27.07.2011**
(21) Anmeldenummer: 10015960.7
(22) Anmeldetag: 22.12.2010
(51) Int. Cl.: H03M 13/09

(54) **Codieren und Decodieren von Daten zur Übertragung über einen fehlerhaften Übertragungskanal**

(30) Priorität: 26.01.2010 DE 102010005702
(71) Anmelder: Fachhochschule Kaiserslautern, 67657 Kaiserslautern (DE)
(72) Erfinder: Bissbort, Achim, 66989 Nünschweiler (DE); Zimmermann, Thomas, 66424 Homburg (DE); List, Gerald, 21521 Wohltorf (DE)
(74) Vertreter: Müller-Boré & Partner Patentanwälte

(57) **Zusammenfassung**

Die vorliegende Erfindung betrifft das Codieren und Decodieren von Daten zur Übertragung über einen fehlerhaften Übertragungskanal (12, 13). Insbesondere betrifft die Erfindung die Vermeidung bzw. Korrektur von Übertragungsfehlern. Dabei umfasst insbesondere ein entsprechendes Codierverfahren ein Unterteilen des Datensatzes in eine Vielzahl von Informationsdatenpaketen, wobei jedes Informationsdatenpaket eine Vielzahl von Datenelementen umfasst; ein Generieren eines Redundanzdatenpakets zu jedem Informationsdatenpaket derart, dass das Redundanzdatenpaket zumindest ein von den Datenelementen des jeweiligen Informationsdatenpakets abhängiges Datenelement enthält; ein Zusammenfassen einer Vielzahl von Informationsdatenpaketen mit dem jeweils dazu generierten Redundanzdatenpaket und eines Referenzdatenblocks zu einem Codedatenblock, wobei der Referenzdatenblock vordefinierte Datenelemente enthält; und ein Umsortieren einer Vielzahl von Datenelementen innerhalb des Codedatenblocks gemäß einer Codiersortiervorschrift, um einen Transferdatenblock zu erhalten.

## Beschreibung

Die vorliegende Erfindung betrifft das Codieren und Decodieren von Daten zur Übertragung über einen fehlerhaften Übertragungskanal. Insbesondere betrifft die Erfindung die Vermeidung bzw. Korrektur von Übertragungsfehlern.

Um Fehler bei der Übertragung von Daten zu erkennen und zu beheben, werden seit längerem verschiedene Fehlerschutzmechanismen eingesetzt. Vor allem Funkübertragungssysteme sind allgemein anfälliger für Störungen als kabelgebundene Systeme. Durch den Einsatz digitaler Datenübertragungstechniken konnten viele Fehlerquellen von analogen Systemen ausgeschlossen werden. Dennoch können Übertragungsfehler auch in digitalen System nicht vermieden werden. Je nach Übertragungsfehler kann damit ein vollständiger Verlust eines Teils der Information verbunden sein oder eine Übertragung der Information in verfälschter Form vorkommen. Daher werden oft Fehlerschutzcodierungen eingesetzt, um die Auswirkungen von Empfangsfehlern, die durch Störungen während der Übertragung entstehen, zu minimieren.

Als Kanalcodierung bezeichnet man beispielsweise ein Verfahren, bei dem digitale Daten für der Übertragung über gestörte Kanäle durch Hinzufügen von Redundanz gegen Übertragungsfehler geschützt oder die Übertragungsfehler zumindest erkannt werden. Wenn die redundante Zusatzinformationen lediglich auf einen Fehler hindeuten und eine Neuübertragung der Daten erfordern, wird das als Rückwärtsfehlerkorrektur bezeichnet. Genügt die Redundanzinformation, um den Fehler zu korrigieren und wird ein erkannter Fehler nach der Übertragung aus den fehlerhaft übertragenen Daten mittels der redundanten Zusatzinformation korrigiert, handelt es sich um eine Vorwärtsfehlerkorrektur.

Wichtige Kenngrößen bei der Codierung und Übertragung von Informationen über einen fehlerhaften digitalen Kanal sind beispielsweise die Coderate und die Bitfehlerrate. Unter der Coderate *R = kln* versteht man das Verhältnis der Anzahl *k* der Symbole der zu übertragenden Information vor dem Codieren, d.h. der Menge an Nutzdaten, zu der Anzahl n an Symbolen nach dem Codieren, d.h. der Anzahl n an Codesymbolen, die tatsächlich über den fehlerhaften Kanal transportiert werden sollen. Es werden also *k* Informationssymbole auf *n* Codesymbole abgebildet. Eine niedrige Coderate entspricht dabei im Wesentlichen einem großen Anteil an Redundanz in den übertragenen Codedaten. Als Bitfehlerrate bezeichnet man das Verhältnis der Anzahl der fehlerhaft durch einen Informationskanal übertragenen Bits zur Anzahl aller übertragenen Bits. Üblicherweise kann ein Kanalcode mit einer niedrigen Coderate mehr Fehler korrigieren als ein vergleichbarer Kanalcode mit einer hohen Coderate. Andererseits bedeutet eine kleine Coderate (großes n) einen kleineren Anteil an nutzbarer Informationsdichte. Bei einer vorgegebenen Übertragungsrate des Kanals bzw. Kanaldatenrate führt das zu einer kleineren nutzbaren Datenrate bzw. Nutzdatenrate.

Ein Beispiel eines bekannten leistungsfähigen Codierungsverfahrens zur Vorwärtsfehlerkorrektur basiert auf sogenannten Reed-Solomon-Codes, welche mit Blöcken von Symbolen arbeiten und daher zur Klasse der symbolorientierten Blockcodes gehören. Dabei stellen Blockcodes eine Art der Kanalcodierung dar, bei der die benutzten Codewörter alle dieselbe Anzahl an Symbolen haben. Obwohl Blockcodes häufig nicht optimal im Sinne einer minimalen mittleren Codewortlänge sind, schränkt man sich oft auf Blockcodes ein, da die Verarbeitung von Codes mit variabler Länge in der Regel aufwendiger ist. Vor allem die erforderliche Rechenleistung beim Codieren und Decodieren sowie bei der Fehlerkorrektur spielt oft eine wichtige Rolle. Die Rechenleistung und die erforderliche Verarbeitungszeit ist aber auch bei Blockcodes, wie den genannten Reed-Solomon-Codes, ein nicht unwesentlicher Faktor speziell für Echtzeitübertragungen.

Ein weiterer bekannter Fehlerschutzmechanismus ist das sogenannte Interleaving. Dabei werden die Symbole zur Bildung eines Codewortes nicht aufeinander folgend aus dem Datenstrom der zu transferierenden Informationen entnommen, sondern Symbole im Abstand der jeweiligen Interleaving-Distanz bzw. dem Interleave-Faktor bzw. der Interleaving-Rate werden zu einem Codewort zusammengefasst. Mit dieser Technik können insbesondere die Auswirkungen eines sogenannten Burstfehlers, also der Störung mehrerer aufeinander folgender Symbole, minimiert werden. Das Umsortieren der Daten erfordert allerdings sowohl im Sender als auch im Empfänger eine gewisse Latenzzeit, die dadurch bedingt ist, dass immer erste eine gewisse Datenmenge abgewartet werden muss, bevor der Prozess des Umsortierens innerhalb dieser Datenmenge begonnen oder abgeschlossen werden kann. Vor allem für Echtzeitübertragungen spielt diese zusätzliche Verzögerung eine nicht unwesentliche Rolle.

Insbesondere Audio-Codec-Geräte übertragen Audio-Datenströme z.B. von einem Reporter vor Ort ins Funkhaus über Kommunikationsnetze, z.B. via UMTS und/oder ISDN. Bei der Übertragung von Daten kommt es oft zu Übertragungsfehlern. Insbesondere der UMTS-CS-Trägerkanal (CS = circuit switched = leitungsvermittelt) ist netzseitig fehlerbehaftet, was zu teilweise deutlich hörbaren Audio-Fehlern führt.

Aufgabe der vorliegenden Erfindung ist die Verbesserung der digitalen Datenübertragung über einen fehlerhaften digitalen Kanal, insbesondere im Hinblick auf eine schnelle Übertragung mit einer hohen Effizienz der Fehlerkorrektur bei geringem Rechenaufwand. Diese Aufgabe wird durch ein Codier- und ein Decodierverfahren, einen Sender und einen Empfänger sowie ein Computerprogrammprodukt mit den in den unabhängigen Ansprüchen angegebenen Merkmalen gelöst. Bevorzugte Ausführungsformen sind Gegenstand der abhängigen Ansprüche.

Somit bietet die Erfindung insbesondere ein Codierverfahren zum Codieren eines digitalen Datensatzes (im folgenden auch als Informationsdatensatz bezeichnet), insbesondere zur Übertragung der Daten bzw. Informationen über einen (fehlerhaften) Datenkanal bzw. Übertragungskanal, wobei das Verfahren umfasst: ein Unterteilen des Datensatzes in eine Vielzahl von Informationsdatenpaketen, wobei jedes Informationsdatenpaket eine Vielzahl von Datenelementen umfasst. Solche Datenelemente stellen vorzugsweise eine kleinste Einheit von separat manipulierten Daten dar, wie z.B. ein Byte oder ein Bit. Im folgenden wird oft als bevorzugte Ausgestalten der Datenelemente ein Bit herangezogen. In diesem Fall kann ein Datenelement zwei Zustände einnehmen, die oft als "0" und "1" dargestellt werden.

Außerdem umfasst das Verfahren ein Generieren eines Redundanzdatenpakets zu jedem Informationsdatenpaket derart, dass das Redundanzdatenpaket zumindest ein von den Datenelementen des jeweiligen Informationsdatenpakets abhängiges Datenelement als Redundanzdatenelement(e), z.B. in Form eines Paritätsbits enthält. Das Redundanzdatenpaket wird insbesondere aus dem jeweiligen Informationsdatenpaket generiert. Insbesondere enthält das Redundanzdatenpaket Paritätsdaten, wie z.B. eines oder mehrere Paritätsbits, die aus den Daten des jeweiligen Informationsdatenpakets generiert werden. Die vom Redundanzdatenpaket umfassten Daten liefern dabei eine Redundanz derart, dass zumindest ein Mindestmaß an Informationsverlust aus dem Informationsdatenpaket unter Berücksichtigung des zugehörigen Redundanzdatenpakets wiedergewonnen werden kann. Der Begriff "Paket" im Redundanzdatenpaket bedeutet dabei nicht notwendigerweise, dass darin mehr als ein Redundanzdatenelement enthalten sein muss. In einer bevorzugten Ausführungsform werden die Redundanzdatenpakete jeweils von einem Paritätsbit gebildet.

Außerdem umfasst das Verfahren ein Zusammenfassen einer Vielzahl von Informationsdatenpaketen mit dem jeweils dazu generierten Redundanzdatenpaket und eines Referenzdatenblocks zu einem Codedatenblock, wobei der Referenzdatenblock vordefinierte, also von dem zu übertragenden Datensatz unabhängige, Datenelemente als Referenzdaten enthält bzw. insbesondere aus solchen vordefinierten Referenzdaten besteht. Dabei sind im Codedatenblock vorzugsweise jeweils ein Informationsdatenpaket und das zugehörige Redundanzdatenpaket zu einem Codedatenpaket zusammengefasst bzw. gemeinsam angeordnet. Die Vielzahl der Codedatenpakete zusammen mit dem einen Referenzdatenblock bilden damit den Codedatenblock. Dabei ist der Referenzdatenblock im Codedatenblock vorzugsweise als zusammenhängender Datenblock angeordnet, der insbesondere der Vielzahl an Codedatenpaketen vorangestellt oder nachgestellt ist. Dabei stellt der Referenzdatenblock einen Satz von bekannten bzw. vorbestimmten bzw. konstanten Zeichen bzw. Datenelementen, wie z.B. eine feste Bitfolge, dar, der insbesondere bei einer Datenübertragung sowohl dem Sender (zum Codieren) als auch dem Empfänger (zum Decodieren) bekannt ist. Der Referenzdatenblock umfasst dabei eine Anzahl an Datenelementen, die als Referenzblockgröße *CS* vorgegeben ist. Über eine eventuelle Veränderung des Referenzdatenblocks bei der Datenübertragung lassen sich vorzugsweise das Auftreten und die Position eventueller Übertragungsfehler im Datensatz lokalisieren. Dies wird nachfolgend noch im Detail ausgeführt.

Schließlich umfasst das Verfahren ein Umsortieren einer Vielzahl von Datenelementen innerhalb des Codedatenblocks gemäß einer Codiersortiervorschrift, um einen Transferdatenblock zu erhalten. Dieser Transferdatenblock stellt damit zumindest einen Teil der codierten Daten des ursprünglichen digitalen Datensatzes dar. Solange noch nicht alle im ursprünglichen Datensatz enthaltenen Datenelemente entsprechend codiert wurden, werden in analoger bzw. identischer Weise weitere Codedatenblöcke gebildet und gemäß der Codiersortiervorschrift umsortiert um weitere Transferdatenblöcke zu bilden. Die umsortierten Codedatenblöcke bilden somit Transferdatenblöcke, die zusammen einen Transferdatensatz darstellen, der über einen digitalen Datenkanal, wie z.B. UMTS gesendet bzw. übertragen werden kann. Besonders bevorzugt umfasst das Übertragen des Transferdatensatzes über einen digitalen Kanal ein Übertragen des Transferdatensatzes von einem UMTS-Netz in ein ISDN-Netz.

Gemäß einem weiteren Aspekt bietet die Erfindung ein entsprechendes Decodierverfahren zum Decodieren eines übertragenen digitalen Datensatzes (im folgenden auch als Transferdatensatz bezeichnet), welcher insbesondere nach einem erfindungsgemäßen Verfahren insbesondere in einer bevorzugten Ausführungsform codiert wurde. Das Decodierverfahren umfasst dabei ein Erfassen zumindest eines Transferdatenblocks aus dem übertragenen Datensatz, wobei der Transferdatenblock eine Vielzahl von Datenelementen, insbesondere eine Vielzahl von Bits, umfasst.

Außerdem umfasst das Decodierverfahren ein Ermitteln eines Codedatenblocks durch Umsortieren einer Vielzahl von Datenelementen innerhalb des erfassten Transferdatenblocks gemäß einer Decodiersortiervorschrift. Die Decodiersortiervorschrift stellt dabei eine zur Codiersortiervorschrift inverse Vorschrift dar, d.h. unmittelbar hintereinander ausgeführt führen die Decodiersortiervorschrift und die Codiersortiervorschrift zusammen wieder zur Ausgangsstruktur, d.h. sie bilden zusammen die Identitätsabbildung.

Außerdem umfasst das Decodierverfahren ein Identifizieren eines Referenzdatenblocks und einer Vielzahl von Codedatenpaketen im Codedatenblock, wobei jedes Codedatenpaket ein Informationsdatenpaket und ein Redundanzdatenpaket umfasst. Durch die Codiersortiervorschrift bzw. die Decodiersortiervorschrift ist die Zuweisung der einzelnen Datenelemente des Referenzdatenblocks zu jeweiligen Positionen im Transferdatenblock eindeutig festgelegt. Dasselbe gilt für die Datenelemente der Informationsdatenpakete und der Redundanzdatenpakete.

Außerdem umfasst das Decodierverfahren ein Ermitteln zumindest eines fehlerhaften Datenelements in zumindest einem (dadurch) fehlerhaften Informationsdatenpaket aus einer Abweichung zumindest eines Datenelements des Referenzdatenblocks von einem vordefinierten Wert, und ein Korrigieren des Übertragungsfehlers mittels des dem fehlerhaften Informationsdatenpaket zugeordneten Redundanzdatenpakets.

Damit erreicht die Erfindung eine schnelle Übertragung von digitalen Daten mit einer hohen Effizienz der Fehlerkorrektur bei geringem Rechenaufwand. Vor allem im Vergleich zu herkömmlichen Kanalkodierungen bietet die Erfindung eine deutliche Verbesserung hinsichtlich der erforderlichen Rechenleistung und damit der notwendigen Hardwareressourcen. Außerdem kann die Latenzzeit der Datenübertragung selbst bei großer Coderate vergleichsweise gering gehalten werden. Dies ist besonders wünschenswert für Echtzeitübertragungen. Im Rahmen der Erfindung wurde insbesondere erkannt, dass mittels der vorliegende Erfindung beispielsweise Audio-Datenströme via UMTS und/oder ISDN besonders effizient übertragen werden können. So konnten insbesondere die bei einer Übertragung mittels eines UMTS-CS-Trägerkanals herkömmlich auftretenden Audio-Fehler mit nur geringem Rechenaufwand bereits wesentlich verringert werden. So erkannte die Erfindung insbesondere, dass die vorgeschlagenen Verfahren besonders effizient bei einer Datenübertragung im Übertragungskanal von UMTS in ein anderes Netz, z.B. ISDN und umgekehrt eingesetzt werden kann. Erfindungsgemäß wurde erkannt, dass mit den vorgeschlagenen Verfahren der spezifischen Fehlercharakteristik dieses Übertragungskanals sehr wirksam begegnet wird. So wurde insbesondere erkannt, dass die herkömmlich deutlich hörbaren Audio-Fehler zum Großteil in zufälligen Abständen verteilten Blockfehlern bzw. Burstfehlern zuzurechnen sind und dass diese mittels der Erfindung effizient korrigiert werden können. Weitere Details über besonderes bevorzugte Parameter für insbesondere diesen Übertragungskanal sind weiter unter noch ausgeführt.

Vorzugsweise wird das Unterteilen des Datensatzes in eine Vielzahl von Informationsdatenpaketen derart ausgeführt, dass jedes Informationsdatenpaket aus einer Anzahl an im Datensatz (auch als Informationsdatensatz bezeichnet) logisch benachbarten bzw. direkt hintereinander liegenden Datenelementen besteht, die einem vorgegebenen, also für alle Informationsdatenpakete gleichen Wert einer Informationspaketgröße PS entspricht. Alternativ oder zusätzlich wird das Generieren eines Redundanzdatenpakets zu jedem Informationsdatenpaket vorzugsweise derart ausgeführt, dass jedes Redundanzdatenpaket aus einer Anzahl an Datenelementen besteht, die einem vorgegebenen, also für alle Redundanzdatenpakete gleichen Wert einer Redundanzpaketgröße RS entspricht.

In einer bevorzugten Ausführungsform wird das jeweilige Redundanzdatenpaket von einem Paritätsbit gebildet, d.h. das Redundanzdatenpaket bestehlt aus einem einzigen Datenelement, nämlich einem einzigen Bit als Redundanzdatenelement. Die Redundanzpaketgröße RS ist somit vorzugsweise 1. In anderen Ausführungsformen sind jedoch auch Redundanzpaketgrößen RS von 2 oder mehr möglich, d.h. das Redundanzdatenpaket umfasst in diesen Ausführungsformen eine Vielzahl von Bits. Vorzugsweise besteht das Redundanzdatenpaket in diesen Ausführungsformen aus dieser Vielzahl von Bits.

Vorzugsweise wird das Zusammenfassen einer Vielzahl von Informationsdatenpaketen mit dem jeweils dazu generierten Redundanzdatenpaket und eines Referenzdatenblocks zu einem Codedatenblock derart ausgeführt, dass der Codedatenblock aus einer Anzahl an Datenelementen besteht, die einem ganzzahligen Vielfachen eines vorgegebenen, also für alle Codedatenblöcke gleichen Wertes einer Fehlerblockgröße ES entspricht.

Besonders bevorzugt besteht der Codedatenblock aus einer Anzahl an Datenelementen, die einem Produkt aus dem Wert der Fehlerblockgröße ES und dem Wert einer Codepaketgröße *DS* entspricht, wobei sich der Wert der Codepaketgröße *DS* aus der Summe der Werte der Informationspaketgröße PS und der Redundanzpaketgröße RS ergibt. Die Anzahl an Datenelementen im Codedatenblock wird nachfolgend auch Codedatenblockgröße *BS* genannt.

Vorzugsweise umfasst das Umsortieren der Vielzahl von Datenelementen innerhalb des Codedatenblocks einen Interleaving-Prozess mit einer vorgegebenen Interleaving-Rate N und einer Interleaving-Blocklänge, die der Anzahl an Datenelementen im Codedatenblock entspricht. Als Interleaving-Prozess mit einer Interleaving-Rate N und einer Interleaving-Blocklänge IS wird dabei insbesondere im üblichen Sinne ein Umsortieren einer Serie von IS Zeichen (S₁, S₂, S₃, ..., S_{N-1}, S_{N}, S_{N+1}, ... S_{IS}) derart verstanden, dass diese Zeichen in der umsortierten Serie beispielsweise beginnend mit dem ersten Zeichen und gefolgt von den in Abständen N folgenden Zeichen der Serie bis zum Ende der Serie und dann immer wieder von vorne mit beispielsweise dem jeweils ersten noch nicht verwendeten bzw. umsortierte Zeichen beginnend und wieder in Abständen N fortschreitend auftreten.

Die resultierende umsortierte Serie lautet demnach insbesondere: (S₁, S_{N+1}, S_{2N+1}, ... S₂, S_{N+2}, S_{2N+2}, ..., S₃, ...). Insbesondere vorgegebene bzw. vorbestimmte Permutationen der Unterserien (S₁, S_{N+1}, S_{2N+1}, ...), (S₂, S_{N+2}, S_{2N+2}, ...) sollen dabei vorzugsweise auch noch unter die Bedeutung des Interleaving-Prozesses im Sinne der Erfindung fallen. Besonders bevorzugt stimmt die Interleaving-Rate N mit dem Wert der Codepaketgröße *DS* überein. Dadurch werden vorzugsweise im Transferdatensatz N zusammenhängende Transferdatenabschnitte derart erzeugt, dass jeweils die ersten bzw. die zweiten usw. Datenelemente aller Informationsdatenpakete zusammen jeweils einem Transferdatenabschnitt zugeordnet sind. Das Entsprechende gilt für die Datenelemente der Redundanzdatenpakete.

Die Referenzblockgröße *CS* sollte zumindest so groß wie die Interleaving-Rate N sein, um jedem Transferdatenabschnitt zumindest ein Datenelement des Referenzdatenblocks zuzuweisen. Vorzugsweise ist die Referenzblockgröße *CS* aber deutlich größer als die Interleaving-Rate N, vorzugsweise zumindest 4-mal so groß, noch mehr bevorzugt zumindest 16-mal so groß. Insbesondere lässt sich die Bitfehlerrate mit zunehmender Referenzblockgröße *CS* verringern. Um allerdings die Coderate der Datenübertragung nicht ebenfalls zu stark zu reduzieren, ist die Referenzblockgröße *CS* vorzugsweise nicht größer als 75% der Codedatenblockgröße *BS*, noch mehr bevorzugt nicht größer als die Hälfte der Codedatenblockgröße *BS*.

Vorzugsweise umfasst das Decodierverfahren außerdem (insbesondere nach dem Korrigieren soweit dies erforderlich war)
- ein Entfernen des Referenzdatenblocks aus dem (eventuell korrigierten) Codedatenblock; und
- ein Entfernen der Vielzahl von Redundanzdatenpaketen aus der Vielzahl von Codedatenpaketen.

Vorzugsweise umfasst das Ermitteln zumindest eines fehlerhaften Datenelements in zumindest einem fehlerhaften Informationsdatenpaket in einem Decodierverfahren:
- ein Ermitteln zumindest eines von einem vordefinierten Wert abweichenden Datenelements des Referenzdatenblocks;
- ein Bestimmen eines Datenfehlerblocks als zusammenhängender Abschnitt des Transferdatenblocks, welcher das zumindest eine abweichende Datenelement des Referenzdatenblocks umfasst (also vor dem Umsortieren umfasste bzw. enthielt); und
- Ermitteln zumindest eines zu dem bestimmten Datenfehlerblock gehörigen, in einem fehlerhaften Informationsdatenpaket enthaltenen Datenelements als das zumindest eine fehlerhafte Datenelement.

Insbesondere umfasst das Decodieren vorzugsweise ein Vergleichen der Datenelemente des im Codedatenblock ermittelten Referenzdatenblocks mit einem vordefinierten Wert (Sollwerten) für die jeweiligen Datenelemente, um Abweichungen zu ermitteln. Vorzugsweise wird der Datenfehlerblock derart bestimmt, dass er aus einer Anzahl an Datenelementen besteht, die einem vorgegebenen Wert einer Fehlerblockgröße ES entspricht.

In einem weiteren Aspekt betrifft die Erfindung ein Verfahren zum Übertragen eines digitalen Datensatzes umfassend:
- ein Codierverfahren gemäß der vorliegenden Erfindung, insbesondere in einer bevorzugten Ausführungsform, zum Generieren eines Transferdatensatzes aus dem zu übertragenden Datensatz;
- ein Übertragen des Transferdatensatzes über einen digitalen Kanal; und
- ein Decodierverfahren gemäß der vorliegenden Erfindung, insbesondere in einer bevorzugten Ausführungsform.

Vorzugsweise umfasst das Übertragen des Transferdatensatzes über einen digitalen Kanal ein Übertragen des Transferdatensatzes von einem UMTS-Netz in ein ISDN-Netz.

In einem weiteren Aspekt bietet die Erfindung einen Sender zum Senden eines digitalen Datensatzes, umfassend:
- eine Codiereinrichtung zum Codieren des Datensatzes, wobei die Codiereinrichtung ausgelegt ist zum
   -- Unterteilen des Datensatzes in eine Vielzahl von Informationsdatenpaketen, wobei jedes Informationsdatenpaket eine Vielzahl von Datenelementen umfasst;
   -- Generieren eines Redundanzdatenpakets zu jedem Informationsdatenpaket derart, dass das Redundanzdatenpaket zumindest ein von den Datenelementen des jeweiligen Informationsdatenpakets abhängiges Datenelement als Redundanzdatenelement(e), z.B. in Form eines Paritätsbits enthält;
   -- Zusammenfassen einer Vielzahl von Informationsdatenpaketen mit dem jeweils dazu generierten Redundanzdatenpaket und eines Referenzdatenblocks zu einem Codedatenblock, wobei der Referenzdatenblock vordefinierte, also von dem zu übertragenden Datensatz unabhängige, Datenelemente als Referenzdaten enthält bzw. insbesondere aus solchen vordefinierten Referenzdaten besteht; und
   -- Erstellen eines Transferdatenblocks durch Umsortieren einer Vielzahl von Datenelementen innerhalb des Codedatenblocks gemäß einer Codiersortiervorschrift; und
- eine Sendeeinrichtung zum Senden des erstellten Transferdatenblocks.

Insbesondere umfasst die Codiereinrichtung somit ein Interleaver-Modul zum Erstellen des Transferdatenblocks durch einen Interleaving-Prozess.

Vorzugsweise ist die Sendeeinrichtung zum Senden des Transferdatenblocks in ein UMTS-Netz ausgelegt.

Außerdem bietet die Erfindung einen Empfänger zum Empfangen eines digitalen Datensatzes, welcher insbesondere von einem erfindungsgemäßen Sender gesendeten wurde, umfassend:
- eine Empfangseinrichtung zum Empfangen des Transferdatensatzes;
- eine Decodiereinrichtung zum Decodieren des empfangenen Transferdatensatzes, wobei die Decodiereinrichtung ausgelegt ist zum:
   -- Erfassen zumindest eines Transferdatenblocks aus dem empfangenen Transferdatensatz, wobei der Transferdatenblock eine Vielzahl von Datenelementen, insbesondere eine Vielzahl von Bits umfasst; und
   -- Ermitteln eines Codedatenblocks durch Umsortieren einer Vielzahl von Datenelementen innerhalb des erfassten Transferdatenblocks gemäß einer Decodiersortiervorschrift;
   -- Identifizieren eines Referenzdatenblocks und einer Vielzahl von Codedatenpaketen im Codedatenblock, wobei jedes Codedatenpaket ein Informationsdatenpaket und ein Redundanzdatenpaket umfasst;
   -- Ermitteln zumindest eines fehlerhaften Datenelements in zumindest einem fehlerhaften Informationsdatenpaket, insbesondere eines Burstfehlers bei der Übertragung des Transferdatensatzes, aus einer Abweichung zumindest eines Datenelements des Referenzdatenblocks von einem vordefinierten Wert; und
   -- Korrigieren des Übertragungsfehlers mittels des dem fehlerhaften Informationsdatenpaket zugeordneten Redundanzdatenpakets.

Vorzugsweise ist die Empfangseinrichtung zum Empfangen des Transferdatensatzes aus einem ISDN-Netz ausgelegt.

In einem weiteren Aspekt betrifft die Erfindung ein Codierverfahren zum Codieren eines digitalen Datensatzes. Das Verfahren umfasst dabei ein Generieren einer Vielzahl von Codedatenblöcken aus dem Datensatz und ein Erzeugen einer Transferdatensequenz aus der Vielzahl von Codedatenblöcken derart, dass die Transferdatensequenz zu jedem Codedatenblock zusätzlich zum Codedatenblock auch ein dazu identisches Codeblockduplikat umfasst.

Jedes Codeblockduplikat ist somit zumindest vor der Übertragung der Transferdatensequenz über einen möglicherweise fehlerhaften Übertragungskanal identisch zu einem Codedatenblock. Insbesondere sind die Codeblockduplikate in der Transferdatensequenz logisch und/oder zeitlich, mittelbar oder unmittelbar, also mit oder ohne einen logischen bzw. zeitlichen Abstand, hinter bzw. nach dem entsprechenden Codedatenblock angeordnet, werden also insbesondere nach dem entsprechenden Codedatenblock übertragen. Sie stellen insbesondere eine genaue Kopie des jeweiligen Codedatenblocks dar. Dabei wird in der Transferdatensequenz der erste bzw. frühere der beiden übereinstimmenden Datenblöcke als Codedatenblock (oder auch erster Codedatenblock) und der zweite bzw. spätere als Codeblockduplikat (oder auch zweiter Codedatenblock) bezeichnet.

In einer bevorzugten Ausführungsform umfasst das Generieren einer Vielzahl von Codedatenblöcken aus dem Datensatz ein Generieren einer Vielzahl von Codedatenpaketen aus dem Datensatz und ein Zusammenfassen einer Vielzahl von Codedatenpaketen zu einem Codedatenblock. Insbesondere wird die Transferdatensequenz damit derart erzeugt, dass sie eine Vielzahl von Codedatenpaketen und zu jedem Codedatenpaket ein dazu identisches Codepaketduplikat umfasst. Dabei wird in der Transferdatensequenz das erste bzw. frühere der beiden übereinstimmenden Datenpakete als Codedatenpaket (oder auch erstes Codedatenpaket) und das zweite bzw. spätere als Codepaketduplikat (oder auch zweites Codedatenpaket) bezeichnet.

Dabei wird insbesondere eine Vielzahl von Codepaketduplikaten zu einem Codeblockduplikat zusammengefasst. Dabei entspricht insbesondere die logische und/oder zeitliche Reihenfolge der Codepaketduplikate in den Codeblockduplikaten der jeweiligen logischen bzw. zeitlichen Reihenfolge der entsprechenden Codedatenpakete in den entsprechenden Codedatenblöcken. Vorzugsweise werden alle Codedatenblöcke und alle Codeblockduplikate aus gleich vielen Codedatenpaketen bzw. Codepaketduplikaten gebildet. Weiter bevorzugt wird das Generieren einer Vielzahl von Codedatenpaketen, derart ausgeführt, dass jedes Codedatenpaket aus einer Anzahl an Datenelementen besteht, die einem vorgegebenen, also für alle Codedatenpakete gleichen Wert einer Fehlerblockgröße ES entspricht. Besonders bevorzugt weisen somit alle Codedatenblöcke und alle Codeblockduplikate dieselbe Größe auf.

Vorzugsweise wird die Transferdatensequenz derart erzeugt, dass die Codedatenblöcke und die Codeblockduplikate logisch und/oder zeitlich abwechselnd angeordnet sind, d.h. es folgen im Wechsel immer ein Codedatenblock und ein Codeblockduplikat.

Dabei wird die Transferdatensequenz in einer bevorzugten Ausführungsform derart erzeugt, dass zu jedem Codedatenblock das zugehörige Codeblockduplikat innerhalb der Transferdatensequenz logisch und/oder zeitlich unmittelbar hinter bzw. nach dem jeweiligen Codedatenblock angeordnet ist, d.h. die übereinstimmenden Datenblöcke folgen unmittelbar hintereinander, ohne dass dazwischen ein anderer Datenblock, beispielsweise in Form eines Codedatenblocks oder eines Codeblockduplikats beispielsweise der gleichen Länge bzw. Größe oder länger bzw. größer, eingefügt ist.

Vorzugsweise umfasst das Generieren einer Vielzahl von Codedatenpaketen aus dem Datensatz ein Unterteilen des Datensatzes in eine Vielzahl von Informationsdatenpaketen, wobei jedes Informationsdatenpaket eine Vielzahl von Datenelementen umfasst. Außerdem umfasst das Generieren des Vielzahl von Codedatenpaketen vorzugsweise ein Generieren jeweils eines Codedatenpakets aus jeweils einem der Vielzahl von Informationsdatenpaketen derart, dass jedes Codedatenpaket vom jeweiligen Informationsdatenpaket abhängige Redundanzinformation umfasst. Besonders bevorzugt umfasst das Generieren eines Codedatenpakets zu jedem Informationsdatenpaket ein Generieren eines Prüfpakets einer zyklischen Redundanzprüfung (z.B. CRC16). In einer besonders bevorzugten Ausführungsform umfasst jedes Codedatenpaket 1280 Bit, davon vorzugsweise 1264 Bit Nutzdaten und 16 Bit Redundanzinformation (z.B. CRC16), d.h. vorzugsweise umfasst jedes Informationsdatenpaket 1264 Bit und jedes Prüfpaket 16 Bit. In anderen Ausführungsformen sind auch andere Größen für die Codedatenpakete und/oder die Informationsdatenpakete und/oder die Prüfpakete möglich. In einem weiteren bevorzugten Aspekt umfasst jeder Codedatenblock und jedes Codeblockduplikat 4 Codedatenpakete bzw. 4 Codepaketduplikate.

Die erzeugte Transferdatensequenz wird vorzugsweise über einen digitalen Datenkanal, wie z.B. UMTS gesendet bzw. übertragen. Besonders bevorzugt umfasst das Übertragen der Transferdatensequenz über einen digitalen Kanal ein Übertragen der Transferdatensequenz von einem UMTS-Netz in ein ISDN-Netz.

Gemäß einem weiteren Aspekt bietet die Erfindung ein entsprechendes Decodierverfahren zum Decodieren eines übertragenen digitalen Datensatzes, welcher auch als Transferdatensatz bezeichnet werden soll und welcher insbesondere nach einem erfindungsgemäßen Verfahren insbesondere in einer bevorzugten Ausführungsform codiert wurde. Das Decodierverfahren umfasst dabei ein Erfassen zumindest einer Transferdatensequenz aus dem übertragenen Datensatz, wobei die Transferdatensequenz eine Vielzahl von Datenelementen, insbesondere eine Vielzahl von Bits, umfasst. Dabei umfasst die Transferdatensequenz die Vielzahl von Datenelementen in Form einer Vielzahl von Codedatenpaketen und einer Vielzahl von Codepaketduplikaten. Besonders bevorzugt weisen die Codedatenpakete und die Codepaketduplikate dieselbe Größe bzw. Länge, also jeweils dieselbe Anzahl an Datenelementen, auf.

Außerdem umfasst das Decodierverfahren in diesem bevorzugten Aspekt der Erfindung ein Ermitteln zumindest eines ersten Codedatenpakets und zumindest eines dazu korrespondierenden Codepaketduplikats als zweites Codedatenpaket in der erfassten Transferdatensequenz. Dabei entspricht das zweite Codedatenpaket in der Transferdatensequenz einem Datenpaket, das beim Erstellen der Transferdatensequenz vor dessen Übertragung als Kopie des ersten Codedatenpakets erzeugt wurde. Bei der Übertragung der Datentransfersequenz über einen eventuell fehlerhaften Übertragungskanals könnte zumindest eines der beiden Codedatenpakete verändert worden und damit fehlerhaft sein. Die beiden Codedatenpakete werden insbesondere als Teil eines ersten bzw. eines zweiten Codedatenblocks, welche auch als Codedatenblock und Codeblockduplikat bezeichnet werden, in der Datentransfersequenz ermittelt. Besonders bevorzugt werden sie als Abschnitte in der Datentransfersequenz ermittelt, deren Beginn in der Datentransfersequenz um eine vorgegebene Duplikatverschiebung logisch und/oder zeitlich relativ zueinander verschoben sind, wobei die vorgegebene Duplikatverschiebung insbesondere der logischen bzw. zeitlichen Länge der Codedatenblöcke entspricht.

Außerdem umfasst das Decodierverfahren ein Überprüfen einer Konsistenz zumindest eines der beiden ermittelten Codedatenpakete. Die Konsistenz wird dabei insbesondere über die in den ermittelten Codedatenpaketen gemäß einem vorgegebenen Codierverfahren während der Erstellens der Codedatenpakete beim Codieren eingefügten Redundanz überprüft. In Abhängigkeit davon, ob die Konsistenz des zumindest einen überprüften Codedatenpakets festgestellt wurde umfasst das Verfahren ein Ermitteln eines Informationsdatenpakets aus dem zumindest einen überprüften Codedatenpaket, falls dessen Konsistenz festgestellt wurde, bzw. ein Ermitteln eines Informationsdatenpakets aus dem anderen der beiden ermittelten Codedatenpakete, falls die Konsistenz des zumindest einen überprüften Codedatenpakets nicht festgestellt wurde. Die Überprüfung der Konsistenz des anderen der beiden ermittelten Codedatenpakete ist dabei nicht unbedingt erforderlich. Vorzugsweise wird aber auch dessen Konsistenz überprüft, um eine Fehlerfreiheit des ermittelten Informationsdatenpakets zu überprüfen. Wird für keines der beiden Codedatenpakete eine Konsistenz festgestellt, ist ein fehlerfreies Ermitteln des Informationsdatenpakets aus einem der Codedatenpakete eventuell nicht möglich. In diesem Fall wird vorzugsweise ein eventuell fehlerbehaftetes Informationsdatenpaket aus einem der beiden Codedatenpakete ermittelt. Das ermittelte Informationsdatenpaket wird schließlich einem Informationsdatensatz zugeordnet.

Die Schritte des Ermittelns zumindest eines ersten und eines zweiten Codedatenpakets, des Überprüferns der Konsistenz zumindest eines der ermittelten Codedatenpakete, des von der Überprüfung abhängigen Ermittelns eines Informationsdatenpakets und des Zuordnens des ermittelten Informationsdatenpakets zu einem Informationsdatensatz werden vorzugsweise für alle in der erfassten Transferdatensequenz enthaltenen Codedatenpakete und Codepaketduplikate durchgeführt.

Vor allem in diesem Aspekt erreicht die Erfindung eine besonders effiziente und schnelle Übertragung von digitalen Daten bei einer sehr verlässlichen Fehlerkorrektur mit geringem Rechenaufwand. Die Erfindung zeichnet sich bei ihrer Nutzung zur Übertragung von Audio-Datenströme via UMTS und/oder ISDN, insbesondere bei einer Datenübertragung im Übertragungskanal von UMTS in ein anderes Netz, z.B. ISDN, (sog. "uplink") durch die Kombination aus geringer erforderlicher Rechenleistung und geringer Latenzzeit der Datenübertragung aus. Erfindungsgemäß wurde erkannt, dass mit den vorgeschlagenen Verfahren der spezifischen Fehlercharakteristik dieses Übertragungskanals sehr wirksam begegnet wird. So wurde insbesondere erkannt, dass die herkömmlich deutlich hörbaren Audio-Fehler zum Großteil in zufälligen Abständen verteilten Blockfehlern bzw. Burstfehlern zuzurechnen sind und dass diese mittels der Erfindung effizient korrigiert werden können.

In einem weiteren Aspekt betrifft die Erfindung ein Verfahren zum Übertragen eines digitalen Datensatzes umfassend:
- ein Codierverfahren gemäß der vorliegenden Erfindung, insbesondere in einer der beschriebenen bevorzugten Ausführungsformen, zum Generieren einer Transferdatensequenz aus dem zu übertragenden Datensatz;
- ein Übertragen der Transferdatensequenz über einen digitalen Kanal; und
- ein Decodierverfahren gemäß der vorliegenden Erfindung, insbesondere in einer bevorzugten Ausführungsform.

Vorzugsweise umfasst das Übertragen der Transferdatensequenz über einen digitalen Kanal ein Übertragen der Transferdatensequenz von einem UMTS-Netz in ein ISDN-Netz.

In einem weiteren Aspekt bietet die Erfindung einen Sender zum Senden eines digitalen Datensatzes, umfassend:
- eine Codiereinrichtung zum Codieren des Datensatzes, wobei die Codiereinrichtung ausgelegt ist zum
   -- Generieren einer Vielzahl von Codedatenblöcken aus dem Datensatz; und
   -- Erzeugen einer Transferdatensequenz aus der Vielzahl von Codedatenblöcken derart, dass die Transferdatensequenz zu jedem Codedatenblock ein dazu identisches Codeblockduplikat umfasst; und
- eine Sendeeinrichtung zum Senden der erstellten Transferdatensequenz.

Vorzugsweise ist die Codiereinrichtung ausgelegt, ein Codierverfahren nach einer der beschriebenen bevorzugten Ausführungsformen der Erfindung auszuführen, wobei die Sendeeinrichtung vorzugsweise zum Senden der Transferdatensequenz bzw. eines Transferdatenblocks in ein UMTS-Netz ausgelegt ist. Besonders bevorzugt ist die Codiereinrichtung ausgelegt, zwischen verschiedenen Betriebsmodi umgeschaltet zu werden, in denen die Codiereinrichtung jeweils eines der erfindungsgemäßen Codierverfahren, insbesondere in einer der beschriebenen bevorzugten Ausführungsformen, ausführt. Dazu weist der Sender vorzugsweise eine Umschalteinrichtung auf, um zwischen den verschiedenen Betriebsmodi umzuschalten.

Außerdem bietet die Erfindung einen Empfänger zum Empfangen eines digitalen Datensatzes, welcher insbesondere von einem erfindungsgemäßen Sender insbesondere in einer der beschriebenen bevorzugten Ausführungsformen gesendeten wurde, umfassend:
- eine Empfangseinrichtung zum Empfangen des Datensatzes insbesondere aus einem ISDN-Netz; und
- eine Decodiereinrichtung zum Decodieren des empfangenen Datensatzes, wobei die Decodiereinrichtung ausgelegt ist zum:
   -- Erfassen einer Transferdatensequenz aus dem empfangenen Datensatz, wobei die Transferdatensequenz eine Vielzahl von Codedatenpaketen und eine Vielzahl von Codepaketduplikaten umfasst;
   -- Ermitteln zumindest eines ersten Codedatenpakets und zumindest eines dazu korrespondierenden Codepaketduplikats als zweites Codedatenpaket in der erfassten Transferdatensequenz;
   -- Überprüfen einer Konsistenz zumindest eines der beiden ermittelten Codedatenpakete;
   -- in Abhängigkeit davon, ob die Konsistenz des zumindest einen überprüften Codedatenpakets festgestellt wurde:
      --- Ermitteln eines Informationsdatenpakets aus dem zumindest einen überprüften Codedatenpaket, falls dessen Konsistenz festgestellt wurde;
      --- Ermitteln eines Informationsdatenpakets aus dem anderen der beiden ermittelten Codedatenpakete, falls die Konsistenz des zumindest einen überprüften Codedatenpakets nicht festgestellt wurde; und
   -- Zuordnen des ermittelten Informationsdatenpakets zu einem Informationsdatensatz.

Vorzugsweise ist die Decodiereinrichtung ausgelegt, ein Decodierverfahren nach einer der beschriebenen bevorzugten Ausführungsformen der Erfindung auszuführen, wobei die Empfangseinrichtung vorzugsweise zum Empfangen der Transferdatensequenz bzw. eines Transferdatensatzes aus einem ISDN-Netz ausgelegt ist. Besonders bevorzugt ist die Decodiereinrichtung ausgelegt, zwischen verschiedenen Betriebsmodi umgeschaltet zu werden, in denen die Decodiereinrichtung jeweils eines der erfindungsgemäßen Decodierverfahren, insbesondere in einer der beschriebenen bevorzugten Ausführungsformen, ausführt. Dazu weist der Empfänger vorzugsweise eine Umschalteinrichtung auf, um zwischen den verschiedenen Betriebsmodi umzuschalten.

In einer weiteren bevorzugten Ausführungsform eines erfindungsgemäßen Codierverfahrens wird die Transferdatensequenz derart erzeugt, dass darin (logisch und/oder zeitlich) unmittelbar hinter bzw. nach jedem Codedatenblock ein Codeblockduplikat eines anderen Codedatenblocks angeordnet ist. Insbesondere bilden diese zusammen einen Codetransferblock. Somit wird die Transferdatensequenz vorzugsweise aus einer Vielzahl von Codetransferblöcken erzeugt, wobei jeder Codetransferblock insbesondere aus einem Codedatenblock und einem Codeblockduplikat, welches einem anderen Codedatenblock entspricht, zusammengesetzt ist. Dabei sind jeweils innerhalb des Codetransferblocks der Codedatenblock und das nicht diesem Codedatenblock entsprechende Codeblockduplikat logisch und/oder zeitlich vorzugsweise unmittelbar hintereinander bzw. nacheinander angeordnet. Das Erzeugen einer Transferdatensequenz umfasst somit vorzugsweise ein Erstellen der Vielzahl von Codetransferblöcken und logisches und/oder zeitliches Aneinanderreihen der Codetransferblöcke.

Damit sind vorzugsweise Codedatenblöcke und Codeblockduplikate abwechselnd in der Transferdatensequenz angeordnet, wobei jedes Codeblockduplikat vom zugehörigen (also identischen bzw. inhaltsgleichen) Codedatenblock um eine insbesondere vorgegebene, also für alle Codedatenblöcke gleiche bzw. konstante, logische und/oder zeitliche Duplikatverschiebung bzw. Duplikatverzögerung entfernt bzw. beabstandet ist. Damit entspricht die Reihenfolge der Codeblockduplikate in der Transferdatensequenz vorzugsweise der Reihenfolge der entsprechenden Codedatenblöcke. Allerdings ist der Beginn jedes Codeblockduplikats um die vorgegebene Duplikatverschiebung bzw. Duplikatverzögerung gegenüber dem Ende des zugehörigen Codedatenblocks logisch und/oder zeitlich nach hinten verschoben. Die vorgegebene Duplikatverschiebung bzw. Duplikatverzögerung legt insbesondere einen vorgegebenen logischen (insbesondere in einer Anzahl an Bit) und/oder zeitlichen (insbesondere in Sekunden oder Millisekunden) Abstand zwischen einem Codedatenblock und dem zugehörigen Codeblockduplikat fest. Insbesondere entspricht die Duplikatverschiebung bzw. Duplikatverzögerung vorzugsweise einem ganzzahligen Vielfachen, insbesondere einem geradzahligen Vielfachen, der Größe bzw. Länge eines Codedatenblocks, oder die Duplikatverschiebung bzw. Duplikatverzögerung ist als ein ganzzahliges insbesondere geradzahliges Vielfaches der Größe bzw. Länge eines Codedatenblocks festgelegt.

Insbesondere gibt es somit in der Transferdatensequenz im Wesentlichen zu jedem Codetransferblock einen vorderen korrespondierenden Codetransferblock derart, dass das vom Codetransferblock umfasste Codeblockduplikat dem vom vorderen korrespondierenen Codetransferblock umfassten Codedatenblock entspricht bzw. mit diesem übereinstimmt, und einen hinteren korrespondierenden Codetransferblock derart, dass der vom Codetransferblock umfasste Codedatenblock dem vom hinteren korrespondierenden Codetransferblock umfassten Codeblockduplikat entspricht bzw. mit diesem übereinstimmt. Korrespondierende Codetransferblöcke weisen damit vorzugsweise stets die gleichen logischen und/oder zeitlichen Abstände voneinander auf. Insbesondere ist der Beginn korrespondierender Codetransferblöcke um die Duplikatverschiebung bzw. Duplikatverzögerung gegeneinander verschoben. Das gleiche gilt im Prinzip für deren Ende.

Insbesondere in dieser Ausführungsform umfasst das Generieren der Vielzahl von Codedatenblöcken aus dem Datensatz vorzugsweise ein Unterteilen bzw. Gruppieren der im Datensatz enthaltenen Datenelemente in eine Vielzahl von Informationsdatenblöcken. Besonders bevorzugt werden die im Datensatz enthaltenen Datenelemente (z.B. Bits oder Bytes) in der darin festgelegten logischen und/oder zeitlichen Reihenfolge nacheinander zur Erzeugung der Vielzahl von vorzugsweise gleich großen Informationsdatenblöcken zusammengefasst bzw. gruppiert und vorzugsweise unmittelbar als Codedatenblöcke verwendet. In einer bevorzugten Ausführungsform wird hierbei auf weitere Codierungsschritte, insbesondere auf das Einfügen zusätzlicher Redundanz bei der Erstellung von Codedatenblöcken aus den Informationsdatenblöcken verzichtet. Dadurch ist bei überraschend guter Fehlerkorrektur ein vergleichsweise geringer Rechenaufwand erforderlich.

Gemäß einem weiteren Aspekt bietet die Erfindung ein entsprechendes Decodierverfahren zum Decodieren eines übertragenen digitalen Datensatzes, welcher insbesondere nach einem erfindungsgemäßen Verfahren insbesondere in einer der soeben beschriebenen bevorzugten Ausführungsformen codiert wurde. Das Decodierverfahren umfasst dabei ein Erfassen einer Transferdatensequenz aus dem übertragenen Datensatz, wobei die Transferdatensequenz eine Vielzahl von insbesondere gleich langen Codetransferblöcken derart umfasst, dass jeder Codetransferblock einen Codedatenblock und ein Codeblockduplikat umfasst. Insbesondere gibt es dabei, wie bereits oben beschrieben, in der Transferdatensequenz im Wesentlichen zu jedem Codetransferblock einen vorderen korrespondierenden Codetransferblock derart, dass das vom Codetransferblock umfasste Codeblockduplikat dem vom vorderen korrespondierenen Codetransferblock umfassten Codedatenblock entspricht, d.h. durch die Codier-/Decodiervorschrift als bei fehlerfreier Übertragung übereinstimmend festgelegt ist, und einen hinteren korrespondierenden Codetransferblock derart, dass der vom Codetransferblock umfasste Codedatenblock dem vom hinteren korrespondierenden Codetransferblock umfassten Codeblockduplikat entspricht, d.h. durch die Codier-/Decodiervorschrift als bei fehlerfreier Übertragung übereinstimmend festgelegt ist.

Außerdem umfasst das Decodierverfahren ein Vergleichen des Codedatenblocks eines ersten Codetransferblocks mit dem Codeblockduplikat eines zweiten Codetransferblocks, wobei der Beginn des zweiten Codetransferblocks in der erfassten Transferdatensequenz um eine vorbestimmte Duplikatverschiebung, insbesondere um eine vorbestimmte Anzahl an Datenblöcken und/oder Datenelementen (z.B. Bits), vom Beginn des ersten Codetransferblocks logisch und/oder zeitlich entfernt ist, also insbesondere nach hinten verschoben ist. D.h. der zweite Codetransferblock beginnt in der Transferdatensequenz logisch und/oder zeitlich um die vorbestimmte Duplikatverschiebung weiter hinten bzw. später als der erste Codetransferblock. Durch den Vergleich wird insbesondere festgestellt, ob der erste Codetransferblock den vorderen korrespondierenden Codetransferblock zum zweiten Codetransferblocks darstellt, bzw. ob der zweite Codetransferblock den hinteren korrespondierenden Codetransferblock zum ersten Codetransferblocks darstellt.

Falls keine Übereinstimmung festgestellt wird, wird daraus geschlossen, dass während der Übertragung zumindest ein Codetransferblock zwischen dem ersten und zweiten Codetransferblock zumindest teilweise verloren gegangen ist. Auf diese Weise ermöglicht das Verfahren insbesondere ein Ermitteln des Fehlens eines oder mehrerer Datenblöcke, insbesondere Datenblöcke oder Datensegmente mit einer Länge, die der Länge eines oder mehrerer Codetransferblöcke entspricht, in der Transferdatensequenz.

Um einen entsprechenden Verlust von Transferdaten zu kompensieren, umfasst das Decodierverfahren in Abhängigkeit davon, ob im Schritt des Vergleichens im Wesentlichen eine Übereinstimmung des Codedatenblocks des ersten Codetransferblocks mit dem Codeblockduplikat des zweiten Codetransferblocks festgestellt wurde, ein Ermitteln eines Informationsdatenblocks aus dem Codedatenblock des ersten Codetransferblocks und/oder aus dem Codeblockduplikat des zweiten Codetransferblocks, falls im Schritt des Vergleichens im Wesentlichen eine Übereinstimmung festgestellt wurde, bzw. ein Ermitteln eines Informationsdatenblocks aus dem Codedatenblock des ersten Codetransferblocks und Ermitteln eines weiteren Informationsdatenblocks aus dem Codeblockduplikat eines dritten Codetransferblocks, wobei der logische und/oder zeitliche Beginn des dritten Codetransferblocks in der erfassten Transferdatensequenz um die vorbestimmte Duplikatverschiebung vom Beginn des zweiten Codetransferblocks logisch und/oder zeitlich entfernt ist, also insbesondere nach hinten verschoben ist, falls im Schritt des Vergleichens im Wesentlichen keine Übereinstimmung festgestellt wurde.

Der dritte Codetransferblock entspricht dabei nämlich insbesondere dem hinteren korrespondierenden Codetransferblock eines zumindest teilweise bei der Übertragung verloren gegangenen Codetransferblocks. Die in dem Codedatenblock des zumindest teilweise verloren gegangenen Codetransferblocks enthaltenen Informationen sind aber insbesondere nochmals im Codeblockduplikat des dritten Codetransferblocks enthalten und werden entsprechend für die Rekonstruktion des Informationsdatensatzes herangezogen.

Schließlich erfasst das Decodierverfahren ein Zuordnen der ermittelten Informationsdatenblöcke zu einem Informationsdatensatz. Soweit die Informationsdaten in den Codedatenblöcken bzw. Codeblockduplikaten nicht weiter codiert bzw. verschlüsselt sind, insbesondere durch eine zusätzliche Redundanz, werden die Datenelemente des jeweiligen Codedatenblocks bzw. Codeblockduplikats direkt als Datenelemente des entsprechenden Informationsdatenblocks übernommen. Andernfalls werden sie gemäß dem entsprechenden zusätzlichen Codier-/Decodierprozess ermittelt.

Im Schritt des Vergleichens wird somit untersucht, ob im Wesentlichen eine Übereinstimmung des Codedatenblocks des ersten Codetransferblocks mit dem Codeblockduplikat des zweiten Codetransferblocks vorliegt. Der Codedatenblock des ersten Codetransferblocks stimmt insbesondere dann "im Wesentlichen" mit dem Codeblockduplikat des zweiten Codetransferblocks überein, wenn die Unterschiede bzw. Abweichungen von einer genauen Übereinstimmung, also von einer vollständigen Identität, kleiner oder zumindest nicht größer sind als in vorgegebenen Fehlertoleranzkriterien festgelegt. In einer bevorzugten Ausführungsform werden dabei als Fehlertoleranzkriterien eine Anzahl an Datenelementen, insbesondere Bits, als Toleranzgrenzwert für noch erlaubte oder nicht mehr erlaubte Abweichungen festgelegt. Liegt die Anzahl der beim Vergleichen festgestellten abweichenden Datenelemente unterhalb oder zumindest nicht oberhalb dieses Toleranzgrenzwerts, gelten die verglichenen Datenblöcke als "im Wesentlichen" übereinstimmend. Andernfalls wird "im Wesentlichen" keine Übereinstimmung festgestellt. In einer speziellen Ausführungsform kann als Fehlertoleranzkriterien festgelegt sein, dass kein einziges Datenelement abweichen darf, wenn "im Wesentlichen" eine Übereinstimmung festgestellt werden soll. Insbesondere in diesem Fall müssen die Fehlertoleranzkriterien nicht explizit, also als eigener Parameterwert, vorgegeben werden. Vielmehr können in diesem Fall die Fehlertoleranzkriterien als implizit in dem Identitätsvergleich enthalten betrachtet werden.

Vor allem in diesem Aspekt erreicht die Erfindung eine besonders effiziente und schnelle Übertragung von digitalen Daten bei einer sehr verlässlichen Fehlerkorrektur mit geringem Rechenaufwand. Die Erfindung zeichnet sich bei ihrer Nutzung zur Übertragung von Audio-Datenströme via UMTS und/oder ISDN, insbesondere bei einer Datenübertragung im Übertragungskanal in ein UMTS-Netz von einem anderen Netz, z.B. ISDN, (sog. "downlink") durch die Kombination aus geringer erforderlicher Rechenleistung und geringer Latenzzeit der Datenübertragung aus.

Erfindungsgemäß wurde erkannt, dass mit den vorgeschlagenen Verfahren der spezifischen Fehlercharakteristik dieses Übertragungskanals sehr wirksam begegnet wird. So wurde insbesondere erkannt, dass die herkömmlich deutlich hörbaren Audio-Fehler zum Großteil fehlenden, also verlorengegangenen Datenblöcken in zufälligen Abständen und mit Blocklängen, die einem ganzzahligen Vielfachen einer minimalen Blocklänge entspricht, zuzurechnen sind und dass diese mittels der Erfindung effizient korrigiert werden können. Dazu wird als Länge bzw. Größe der Codetransferblöcke insbesondere die minimale Blocklänge der auftretenden Blockfehler vorgesehen, d.h. die Codedatenblöcke und die Codeblockduplikate werden mit einer Größe bzw. Länge vorgesehen, die der Hälfte der Größe bzw. Länge der minimalen Blockfehler entspricht. In einer besonders bevorzugten Ausführungsform wird als minimale Blocklänge der auftretenden Blockfehler ein Wert von 80 Byte bzw. 640 Bit verwendet. Als Länge der Codedatenblöcke und Codeblockduplikate wird somit vorzugsweise ein Wert von 40 Byte bzw. 320 Bit verwendet. Besonders bevorzugt wird als Duplikatverschiebung ein Wert verwendet, der einer Größe bzw. Länge von 8 Codedatenblöcken bzw. Codeblockduplikaten, also vorzugsweise einer Größe bzw. Länge von 4 Codetransferblöcken, insbesondere 320 Byte bzw. 2560 Bit entspricht.

In einem weiteren Aspekt betrifft die Erfindung ein Verfahren zum Übertragen eines digitalen Datensatzes umfassend:
- ein Codierverfahren gemäß der vorliegenden Erfindung, insbesondere in einer der beschriebenen bevorzugten Ausführungsformen, zum Generieren einer Transferdatensequenz aus dem zu übertragenden Datensatz;
- ein Übertragen der Transferdatensequenz über einen digitalen Kanal; und
- ein Decodierverfahren gemäß der vorliegenden Erfindung, insbesondere in einer bevorzugten Ausführungsform.

Vorzugsweise umfasst das Übertragen der Transferdatensequenz über einen digitalen Kanal ein Übertragen der Transferdatensequenz von einem ISDN-Netz in ein UMTS-Netz. Entsprechend ist in einem erfindungsgemäßen Sender die Codiereinrichtung vorzugsweise ausgelegt, ein erfindungsgemäßes Codierverfahren insbesondere gemäß einer der beschriebenen bevorzugten Ausführungsformen auszuführen. Dabei ist die Sendeeinrichtung vorzugsweise ausgelegt zum Senden der Transferdatensequenz in ein ISDN-Netz.

In einem weiteren Aspekt bietet die Erfindung einen Empfänger zum Empfangen eines digitalen Datensatzes, welcher insbesondere von einem erfindungsgemäßen Sender insbesondere in einer der beschriebenen bevorzugten Ausführungsformen gesendet wurde, umfassend:
- eine Empfangseinrichtung zum Empfangen des Datensatzes insbesondere aus einem UMTS-Netz; und
- eine Decodiereinrichtung zum Decodieren des empfangenen Datensatzes, wobei die Decodiereinrichtung ausgelegt ist zum:
   -- Erfassen einer Transferdatensequenz aus dem übertragenen Datensatz, wobei die Transferdatensequenz eine Vielzahl von Codetransferblöcken derart umfasst, dass jeder Codetransferblock einen Codedatenblock und ein Codeblockduplikat umfasst;
   -- Vergleichen des Codedatenblocks eines ersten Codetransferblocks mit dem Codeblockduplikat eines zweiten Codetransferblocks, wobei der Beginn des zweiten Codetransferblocks in der erfassten Transferdatensequenz um eine vorbestimmte Duplikatverschiebung vom Beginn des ersten Codetransferblocks entfernt ist;
   -- in Abhängigkeit davon, ob im Schritt des Vergleichens im Wesentlichen eine Übereinstimmung des Codedatenblocks des ersten Codetransferblocks mit dem Codeblockduplikat des zweiten Codetransferblocks festgestellt wurde:
      --- Ermitteln eines Informationsdatenblocks aus dem Codedatenblock des ersten Codetransferblocks und/oder aus dem Codeblockduplikat des zweiten Codetransferblocks, falls im Schritt des Vergleichens im Wesentlichen eine Übereinstimmung festgestellt wurde; oder
      --- Ermitteln eines Informationsdatenblocks aus dem Codedatenblock des ersten Codetransferblocks und Ermitteln eines weiteren Informationsdatenblocks aus dem Codeblockduplikat eines dritten Codetransferblocks, wobei der Beginn des dritten Codetransferblocks in der erfassten Transferdatensequenz um die vorbestimmte Duplikatverschiebung vom Beginn des zweiten Codetransferblocks entfernt ist, falls im Schritt des Vergleichens im Wesentlichen keine Übereinstimmung festgestellt wurde; und
   -- Zuordnen der ermittelten Informationsdatenblöcke zu einem Informationsdatensatz.

Vorzugsweise ist in einem erfindungsgemäßen Empfänger die Decodiereinrichtung ausgelegt, ein erfindungsgemäßes Decodierverfahren insbesondere gemäß einer der beschriebenen bevorzugten Ausführungsformen auszuführen.

Außerdem bietet die Erfindung ein Computerprogrammprodukt, insbesondere einen Form eines Datenträgers bzw. Signalträgers als Speicher bzw. Trägermedium, mit Programmcode, der, wenn er auf einem Computersystem geladen ist, das System veranlasst, einen oder mehrere Schritte nach einem erfindungsgemäßen Verfahren insbesondere in einer bevorzugten Ausführungsform auszuführen.

Nachfolgend wird die Erfindung anhand bevorzugter Ausführungsformen mit Verweis auf die beigefügten Figuren beispielhaft beschrieben. Dabei zeigen:
- Fig. 1: einen beispielhaften Übertragungskanal zur Anwendung der vorliegenden Erfindung in einer bevorzugten Ausführungsform;
- Fig. 2: ein Flussdiagramm zur Veranschaulichung einer Codierverfahrens gemäß einer bevorzugten Ausführungsform der vorliegenden Erfindung;
- Fig. 3: ein Flussdiagramm zur Veranschaulichung einer Fehlerkorrektur im Rahmen einer Decodierung in einer bevorzugten Ausführungsform eines erfindungsgemäßen Verfahrens;
- Fig. 4: eine Darstellung zur Veranschaulichung der Datenmanipulation bei der Übertragung von Daten, insbesondere im "uplink", in einer bevorzugten Ausführungsform eines erfindungsgemäßen Verfahrens;
- Fig. 5: eine Darstellung zur Veranschaulichung der Datenmanipulation bei der Codierung (Fig. 5A) bzw. der Decodierung (Fig.5B), insbesondere im "upiink" in einer weiteren bevorzugten Ausführungsform eines erfindungsgemäßen Verfahrens; und
- Fig. 6: eine Darstellung zur Veranschaulichung der Datenmanipulation bei der Codierung (Fig. 6A) bzw. der Decodierung (Fig. 6B), insbesondere im "downlink", in einer weiteren bevorzugten Ausführungsform eines erfindungsgemäßen Verfahrens.

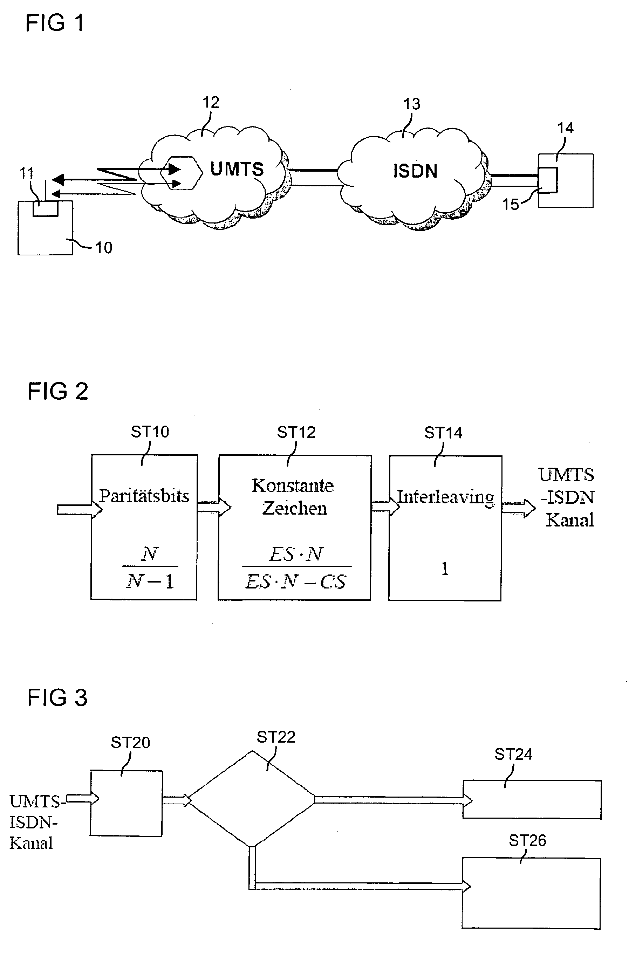

Fig. 1 zeigt eine beispielhafte Übertragungsstrecke bzw. einen beispielhaften Übertragungskanal in dem die Erfindung in besonders bevorzugter Weise Anwendung findet. Dabei ist ein Sender 10 vorzugsweise als mobiles Gerät ausgebildet. Insbesondere ist der Sender 10 ein Codec-Gerät mit Mobilfunkmodem als Sendeeinrichtung 11 oder beispielsweise ein entsprechend ausgerüsteter Laptop zum Senden von Daten über einen Übertragungskanal, insbesondere in ein UMTS-Netz 12. Aus dem UMTS-Netz 12 werden die Daten vorzugsweise über ein ISDN-Netz 13 zu einem Empfänger 14 übertragen. Der Empfänger 14 ist vorzugsweise als fixes Gerät, insbesondere als ein Codec oder ein geeigneter PC mit einer Empfangseinrichtung 15 zum Empfangen der übertragenen Daten ausgestaltet. Diese bevorzugte Konstellation bietet insbesondere eine 64 kbit/s-Verbindung und nutzt vorzugsweise die übliche Outband-Signalisierung Nr 7 (SS7), die regelmäßig bei gewöhnlichen Telefonaten eingesetzt wird. Dadurch wird ein transparenter 64 kbit/s-Kanal vom mobilen Sender 10 über die Funkstrecke und Kernkomponenten von UMTS über ISDN zum Empfänger 14 aufgebaut.

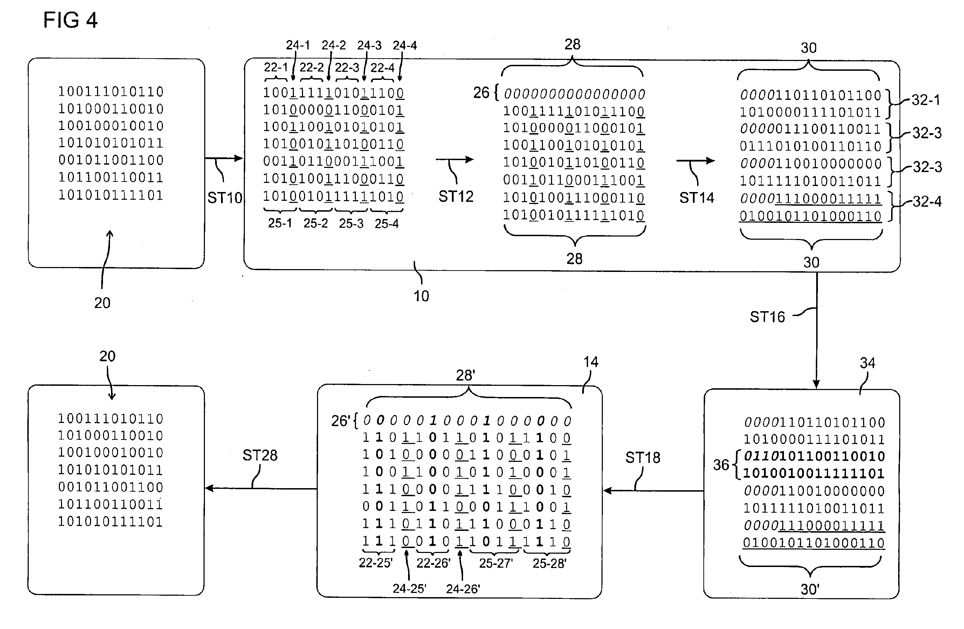

Zur Veranschaulichung einer erfindungsgemäßen Übertragung von Daten, insbesondere eines Audio-Datenstroms, zeigt Fig. 4 ein einfaches Beispiel einer entsprechenden Datenmanipulation gemäß einer bevorzugten Ausführungsform. Auch wenn die zur Veranschaulichung hier verwendeten Parameter vereinfacht dargestellt sind und nur ein reduzierter Datensatz gezeigt ist, lässt sich das Prinzip des Codierens, des Übertragens und des Decodierens einschließlich einer eventuell nötigen Fehlerkorrektur sehr gut erkennen.

Dabei startet der Prozess mit einem Informationsdatensatz 20, der in einer Quellencodierung mit einer Vielzahl von Datenelementen in Form einzelner Bits vorliegt. Datenelemente werden in diesem Beispiel durchwegs als Bits betrachtet und sind in Fig. 4 als "0" und "1" dargestellt. In einem ersten Schritt ST10 wird der Informationsdatensatz 20 in eine Vielzahl von Informationsdatenpaketen (22-1, 22-2, 22-3, 22-4) unterteilt. Im vorliegenden Beispiel wird eine Informationspaketgröße PS = 3 festgelegt, d.h. jedes Informationsdatenpaket 22-x enthält 3 Datenelemente, insbesondere 3 Bits. Die Informationspaketgröße ergibt sich vorzugsweise aus einer festgelegten bzw. bestimmten Interleaving-Rate N (in diesem Beispiel N= 4) und einer vorgegebenen Redundanzpaketgröße *RS* (in diesem Beispiel *RS =* 1) zu *PS = N - RS.* Vorzugsweise kann die Interleaving-Rate *N* von einem Benutzer eingestellt werden und/oder sie ist in Abhängigkeit von einem gewählten Übertragungskanals vorgegeben. Außerdem wird zu jedem Informationsdatenpaket 22-x ein Redundanzdatenpaket (24-1, 24-2, 24-3, 24-4) der Länge RS = 1, also ein Bit als Paritätsbit generiert und dem jeweiligen Informationsdatenpaket 22-x zugeordnet. In der Darstellung von Fig. 4 sind die Paritätsbits 24-x durchwegs als unterstrichene Ziffern ("0" oder "1 ") dargestellt, um sie während der Datenmanipulation leichter verfolgen zu können. Jedes Informationsdatenpaket 22-x bildet zusammen mit dem zugehörigen Redundanzdatenpaket 24-x ein Codedatenpaket (25-1, 25-2, 25-3, 25-4) der Codepaketgröße DS = *PS* + *RS* = 4. Die Gesamtzahl der Bits hat sich damit im Schritt ST10 um 1 Redundanzbit pro 3 Informationsbits erhöht. Der Beitrag dieser Veränderung im Schritt ST10 zur Coderate ist in Fig. 2 als Veränderungsfaktor der Datengröße veranschaulicht.

In dem Beispiel von Fig. 4 werden in einem nächsten Schritt ST12 alle dargestellten Codedatenpakete 25-x zusammen mit einem Referenzdatenblock 26 mit einer Referenzblockgröße *CS* = 16 zu einem Codedatenblock 28 zusammengefasst. In dem dargestellten bevorzugten Ausführungsbeispiel ist ein Wert einer Fehlerblockgröße von ES = 32 festgelegt bzw. bestimmt. Vorzugsweise kann dieser Wert von einem Benutzer eingestellt werden und/oder er ist insbesondere in Abhängigkeit von einem gewählten Übertragungskanals vorgegeben. Vorzugsweise wird eine Codedatenblockgröße *BS* als Anzahl der Datenelemente (Bits) im Codedatenblock 28 auf Basis der vorgegebenen Fehlerblockgröße ES und der vorgegebenen bzw. bestimmten Interleaving-Rate N gemäß *BS = ES* * N, d.h. als Produkt dieser beiden Werte ermittelt. Im vorliegenden Beispiel führt dies zu einer Codedatenblockgröße von BS = 128. Dabei werden insbesondere genau so viele Codedatenpakete 25-x in den Codedatenblock 28 aufgenommen, dass nach Ergänzung um den Referenzdatenblock 26 die erforderliche Codedatenblockgröße *BS* erreicht ist. Es werden somit (ES * *N-* CS) = 112 Bits, also 28 Codedatenpakete 25-x mit einem Referenzdatenblock 26 kombiniert. Der Beitrag der Veränderung im Schritt ST12 zur Coderate ist in Fig. 2 als Veränderungsfaktor der Datengröße veranschaulicht.

Der Referenzdatenblock 26 ist in der ersten Zeile nach Schritt ST12 dargestellt und ist in diesem Beispiel durch 16 konstante Zeichen "0" beschreiben. Dieser Referenzdatenblock 26 ist sowohl dem Sender als auch dem Empfänger bekannt und vorzugsweise für alle Codedatenblöcke 28 während der Datenübertragung der gleiche. In der Darstellung von Fig.4 sind die Datenelemente des Referenzdatenblocks 26 durchwegs als kursive Ziffern dargestellt, um sie während der Datenmanipulation leichter verfolgen zu können. Die Redundanzdatenpakete 24-x sind nach dem Schritt ST12 weiterhin in der 4., 8., 12. und 16. Spalte ab der 2. Zeile als unterstrichene Ziffern dargestellt.

In einem weiteren Schritt ST14 in Fig. 4 erfolgt ein Umsortieren einer Vielzahl von Datenelementen (Bits) innerhalb des Codedatenblocks 28, wodurch ein Transferdatenblock 30 entsteht. In dem dargestellten Beispiel erfolgt das Umsortieren als ein Interleaving-Prozess mit der Interleaving-Rate N= 4 und der Blocklänge *BS* = 128. Dieser Interleaving-Prozess fügt keine zusätzlichen Daten hinzu, weshalb sich im Schritt ST14 keine Veränderung der Coderate ergibt (Faktor 1 in Fig. 2). Durch den Interleaving-Prozess umfasst der Transferdatenblock 30 eine Vielzahl von Transferdatenabschnitten (32-1, 32-2, 32-3, 32-4), deren Größe der Fehlerblockgröße ES entspricht. Jeder Transferdatenabschnitt umfasst genau ein Bit aus jedem Codedatenpaket 25-x und zusätzlich ein oder mehrere Datenelemente (Bits) aus dem Referenzdatenblock 26. Der letzte Transferdatenabschnitt 32-4 enthält dabei sämtliche Paritätsbits, also sämtliche Redundanzdatenpakete 24-x.

Der Transferdatenblock 30 wird in einem Schritt ST16 vom Sender 10 an den Übertragungskanal 34 gesendet. Der Übertragungskanal 34 kann nun Quelle für Übertragungsfehler sein. In einem Aspekt der Erfindung wurde erkannt, dass insbesondere die Folgen von blockweise auftretende Fehlern in zufälligen Abständen (sog. Burstfehler) mit einem erfindungsgemäßen Verfahren besonders effizient verringert oder beseitigt werden können. Insbesondere wurde erfindungsgemäß erkannt, dass gerade bei einer Übertragung von Audio-Datenströmen in einem Übertragungskanal von einem UMTS-Netz in ein anderes Netz, insbesondere in ein ISDN-Netz die herkömmlich deutlich hörbaren Audio-Fehler wirksam und mit geringem Rechenaufwand und vergleichsweise niedriger Latenzzeit gemindert werden können. Fig. 4 zeigt beispielhaft das Auftreten eines Burstfehlers im zweiten Transferdatenabschnitt 32-x. Dieser Abschnitt ist nun ersetzt durch einen Fehlerblock 36, dessen Größe der Fehlerblockgröße *ES* und damit insbesondere der Größe eines bzw. jedes der Transferdatenabschnitte 32-x entspricht. Damit ist genau das zweite Bit in jedem der Codedatenpakete (entspricht in diesem Fall auch dem zweiten Bit der Informationsdatenpakete 22-x) zerstört. Erfindungsgemäß kann dies aber in einem Decodierungsvorgang erkannt und korrigiert werden, wie im weiteren Verlauf beschrieben wird. In der Darstellung von Fig. 4 sind die eventuell veränderten Datenelemente des Fehlerblocks 36 durchwegs als fett beschriebene Ziffern dargestellt, um sie während der Datenmanipulation leichter verfolgen zu können.

In einem Schritt ST18 erfasst ein Empfänger 14 den verfälschten bzw. fehlerbehafteten Transferdatenblock 30' vom Übertragungskanal 34 und sortiert die Datenelemente (Bits) wieder um, so dass in dem dargestellten Beispiel wieder alle Bits des nunmehr verfälschten bzw. fehlerbehafteten Referenzdatenblocks 26' in der ersten Zeile stehen. Dieses Umsortieren gemäß einer Decodiersortiervorschrift erfolgt in einem Schritt ST20 des Deinterleaving (Fig. 3). Dabei entsteht ein Codedatenblock 28', der von der Struktur dem Codedatenblock 28 vor der Übertragung entspricht, eventuell aber Übertragungsfehler aufweist. Insbesondere umfasst der Codedatenblock 28' den eventuell fehlerhaften Referenzdatenblock 26' und eine Vielzahl eventuell fehlerhafter Codedatenpakete 25-x', welcher wiederum jeweils ein Informationsdatenpaket 22-x' und ein Redundanzdatenpaket 24-x' enthalten. Anschließend werden in einem Schritt ST22 die "konstanten Zeichen", also die Datenelemente des Referenzdatenblocks 26' überprüft. Es wird insbesondere überprüft, ob sie den erwarteten (unveränderten bzw. konstanten) Werten entsprechen. Falls alle Referenzdaten den erwarteten Werten entsprechen, also nicht verändert wurden, wird davon ausgegangen, dass kein Fehler, insbesondere kein Burstfehler aufgetreten ist, und der Referenzdatenblock 26' sowie die Redundanzdatenpakete (Paritätsbits) werden in einem Schritt ST24 entfernt, um den Informationsdatensatz 20 wiederherzustellen.

In dem dargestellten Beispiel von Fig. 4 ist allerdings zu erkennen, dass zwei der Bits des Referenzdatenblocks 26' nicht den erwarteten Werten entsprechen, sondern einen veränderten Wert "1" aufweisen. Falls die Position dieser veränderten Bits lediglich auf eine Veränderung der Paritätsbits, also der Redundanzdatenpakete hinweisen, die Informationsdatenpakete aber unverändert scheinen, werden ebenfalls wie in Schritt ST24 der Referenzdatenblock 26' sowie die Redundanzdatenpakete 24-x' (Paritätsbits) entfernt, um den Informationsdatensatz 20 wiederherzustellen. Weichen allerdings, wie im Beispiel von Fig.4, Datenelemente des Referenzdatenblocks 26' ab, die auf fehlerhafte Bits innerhalb der Informationsdatenpakete 22-x' hinweisen, so werden diese fehlerhaften Bits in einem Schritt ST26 mit Hilfe der Redundanzdatenpakete 24-x' errechnet, also wiederhergestellt, um nach Entfernen des Referenzdatenblocks 26' und der Redundanzdatenpakete 24-x' (Paritätsbits) in einem Schritt ST28 den Informationsdatensatz 20 wieder zu erhalten.

Insbesondere bei der Anwendung der Erfindung auf einen der beschriebenen UMTS/ISDN-Übertragungskanäle, und dabei insbesondere im "upstream" (auch "uplink" genannt), werden vorzugsweise folgende Werte als besonders effizient vorgeschlagen:
- Redundanzpaketgröße *RS* = 1 (ein Paritätsbit für drei Informationsdatenbits)
- Interleaving-Rate N= 4
- Referenzblockgröße *CS* = 128 Bit
- Fehlerblockgröße *ES* = 1280 Bit

Im Rahmen weiterer bevorzugter Ausführungsform wird insbesondere im Rahmen der sonstigen bevorzugten Beziehungen zwischen der Zahlenwerten für eine oder mehrere der genannten Größen vorzugsweise die Hälfte oder noch mehr bevorzugt ein ganzzahliges Vielfaches des hier explizit angegebenen Wertes vorgeschlagen.

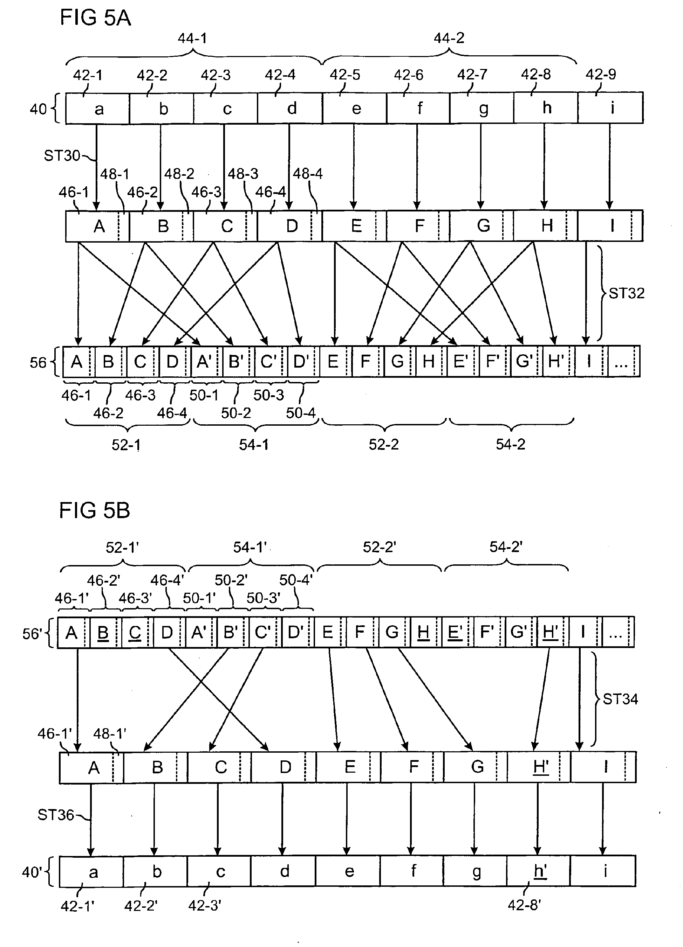

Fig. 5A und Fig. 5B veranschaulichen ein weiteres Beispiel zur Übertragung von Daten, insbesondere zum Codieren (Fig. 5A) und Decodieren (Fig.5B) eines digitalen Datensatzes gemäß einer weiteren bevorzugten Ausführungsform der vorliegenden Erfindung. Das in Fig. 5A dargestellte bevorzugte Codierverfahren geht von einem digitalen Datensatz 40 aus, der in eine Vielzahl von vorzugsweise gleich großen Informationsdatenpakete 42-x (42-1, 42-2, ...) unterteilt wird. Vorzugsweise umfasst jedes der Informationsdatenpakete 42-x eine Vielzahl von Datenelementen, welche insbesondere in einer Quellencodierung die für eine Übertragung zu codierende Information enthalten. Zur einfacheren Nachverfolgung des jeweiligen Informationsgehalts sind die einzelnen Informationsdatenpakete 42-x mit Buchstaben "a", "b", "c", usw. gekennzeichnet bzw. unterschieden.

In der in Fig. 5A dargestellten bevorzugten Ausführungsform bilden jeweils mehrere Informationsdatenpakete 42-x zusammen einen Informationsdatenblock 44-x (44-1, 44-2, ...), aus welchem in einem Schritt ST30 jeweils ein Codedatenblock 52-x (52-1, 52-2, ...) generiert wird. Dazu wird insbesondere aus jedem Informationsdatenpaket 42-x ein Codedatenpaket 46-x (46-1, 46-2, ...) generiert, welches neben den zu übertragenden Informationen des jeweiligen Informationsdatenpakets 42-x auch noch Redundanzinformation beispielsweise in Form eines Prüfpakets 48-x (48-1, 48-2, ...) einer zyklischen Redundanzprüfung (z.B. CRC16) umfasst. Es wird somit zu jedem Informationsdatenpaket eigens eine entsprechende redundante Prüfinformation erzeugt. Die in den dabei entstehenden Codedatenpaketen enthaltene Information einschließlich der jeweiligen Redundanz ist in Fig. 5A durch entsprechende Großbuchstaben "A", "B", "C", usw. dargestellt.

Eine Vielzahl von Codedatenpaketen 46-x bildet zusammen jeweils einen Codedatenblock 52-x. Gemäß der in Fig. 5A dargestellten bevorzugten Ausführungsform wird zur Erzeugung einer Transferdatensequenz 56 in einem Schritt ST32 jedem Codedatenblock 52-1 logisch und/oder zeitlich eine Kopie 54-1 desselben Codedatenblocks als Codeblockduplikat 54-x (54-1, 54-2, ...) angehängt, bevor der nächste Codedatenblock 52-2 folgt. Insbesondere werden somit an die Vielzahl der Codedatenpakete 46-x (z.B. "A", "B", "C", "D") eines ersten Codedatenblocks 52-1 Kopien derselben Codedatenpakete als Codepaketduplikate 50-x (z.B. "A'", "B'", "C'", "D'"), insbesondere in derselben Reihenfolge, angehängt, bevor das erste Codedatenpaket (z.B. "E") des nächsten Codedatenblocks 52-2 folgt. Damit sind in der Transferdatensequenz 56 jeweils Codedatenblöcke 46-x und Codeblockduplikate 50-x abwechselnd angeordnet, wobei insbesondere auf jeden Codedatenblock 46-x das entsprechende bzw. übereinstimmende Codeblockduplikat 50-x unmittelbar folgt.

Die dadurch entstehende Transferdatensequenz 56 wird anschließend insbesondere als Transferdatensatz über einen Übertragungskanal, insbesondere von einem UMTS-Netz (12) in ein ISDN-Netz (13) übertragen. Bei dieser Übertragung können Übertragungsfehler auftreten.

Fig.5B veranschaulicht ein entsprechendes Decodierverfahren zum Decodieren eines übertragenen und empfangenen Datensatzes, insbesondere einer empfangenen Transferdatensequenz 56', welche insbesondere vor der Übertragung mit einem Codierverfahren gemäß der Fig. 5A dargestellten bevorzugten Ausführungsform erzeugt wurde. Durch die Übertragung weist die empfangene Transferdatensequenz 56' im Vergleich zu der vor der Übertragung generierten Transferdatensequenz 56 Übertragungsfehler auf. Diese sind als veränderte Inhalte einiger Codedatenpakete 46-x' oder Codepaketduplikate 50-x' durch unterstrichene Großbuchstaben (z.B. "B", "C", "H", "E ", "H' ") veranschaulicht.

Das Decodierverfahren umfasst ein Erfassen einer Vielzahl von Codedatenpaketen 46-x' (46-1', 46-2', ...) und zu jedem Codedatenpaket 46-x' ein korrespondierendes Codepaketduplikat 50-x' (50-1', 50-2', ...). In Fig. 5B sind die korrespondierenden Paare von Codedatenpaket und Codepaketduplikat mit jeweils demselben Großbuchstaben bezeichnet, wobei jeweils das Codepaketduplikat mit einen zusätzlichen Apostroph gekennzeichnet ist. Dabei wird das zu einem Codedatenpaket (z.B. "A") gehörige Codepaketduplikat (z.B. "A'") insbesondere aus deren logischer und/oder zeitlicher Verschiebung relativ zueinander erkannt. Diese Verschiebung ist insbesondere durch einen vorgegebenen Wert einer Duplikatverschiebung bzw. Duplikatverzögerung festgelegt. Es wird als zu einem ersten Codedatenpaket (z.B. "A") das korrespondierende Codepaketduplikat (z.B. "A'") als zweites Codedatenpaket erfasst.

In der in Fig.5B dargestellten bevorzugten Ausführungsform wird nun in einem Schritt ST34 die Konsistenz des ersten Codedatenpakets "A" auf Basis der im ersten Codedatenpaket enthaltenen Redundanzinformation 48-x' (z.B. 48-1') überprüft. Im vorliegenden Beispiel trat bei der Übertragung kein Fehler im ersten Codedatenpaket "A" auf, weshalb dieses Codedatenpaket "A" zu Wiederherstellung der ursprünglichen Information "a" verwendet wird. Insbesondere wird dazu in einem Schritt ST36 das Informationsdatenpaket 42-x' (z.B. 42-1', "a") aus dem entsprechenden Codedatenpaket 46-x (z.B. 46-1' "A") ermittelt. Die Überprüfung der Konsistenz des korrespondierenden Codepaketduplikats 50-1' ("A'") ist in diesem Fall nicht notwendig.

Im Beispiel von Fig. 5B wird bei einer Überprüfung der nächsten beiden Codedatenpakete 46-2' und 46-3' keine Konsistenz des verfälschten Inhalts "B" bzw. "C" festgestellt. In diesem Fall wird vorzugsweise jeweils das korrespondierende Codepaketduplikat 50-2' bzw. 50-3', dessen Inhalt "B'" bzw. "C'" vor der Übertragung vorzugsweise identisch war zum Inhalt des jeweiligen Codedatenpakets 46-2 bzw. 46-3, für die Ermittlung des jeweiligen Informationsdatenpakets "b" bzw. "c" herangezogen. Soweit die Konsistenz des jeweiligen Codepaketduplikats "B'" bzw. "C'" überprüft wird, kann eine Aussage über die Fehlerfreiheit des resultierenden Datensatzes 40' gewonnen werden. Soweit aber im Falle einer gleichzeitigen Inkonsistenz sowohl eines Codedatenpakets 46-x' als auch dessen korrespondierenden Codepaketduplikats 50-x' eventuell keine weitere Fehlerkorrektur vorgenommen wird, ist die Überprüfung der Konsistenz der Codepaketduplikate 50-x' nicht unbedingt erforderlich. Ein entsprechendes Beispiel ist mit dem fehlerhaften Codedatenblock "H" und dem fehlerhaften korrespondierenden Codeblockduplikat "H'" dargestellt. Hierbei wird nach festgestellter Inkonsistenz des Codedatenblocks "H" das korrespondierende Codeblockduplikat "H"' trotz dessen Inkonsistenz für die Ermittlung des entsprechenden Informationsdatenpakets 42-8' herangezogen. Das resultierende Informationsdatenpaket "h" " ist damit ebenfalls fehlerbehaftet. Im gesamten Datensatz 40' ist aber die gesamte Fehlerhäufigkeit bei vergleichsweise geringem Rechenaufwand und geringer Latenzzeit wesentlich reduziert.

Insbesondere wenn keine weitere Fehlerkorrektur, z.B. auf Grundlage von Redundanzinformation in den Codedatenpaketen 46-x' und/oder Codepaketduplikaten 50-x', vorgenommen wird, werden in einer weiteren bevorzugten Ausführungsform eines erfindungsgemäßen Codier- und/oder Decodierverfahren anstelle von mit Redundanzinformation angereicherten Codepaketduplikaten 50-x' lediglich Kopien der ursprünglichen Informationspakete 42-x, also Informationspaketduplikate, in die Transferdatensequenz 56 eingefügt. Die von der entsprechenden Vielzahl an Informationspaketduplikaten gebildeten Codeblockduplikate 54-x sind in diesem Fall vorzugsweise lediglich in Bezug auf den Nutzdateninhalt identisch zu bzw. entsprechend den jeweiligen Codedatenblöcken 52-x. Sie enthalten in diesem Fall, anders als die jeweiligen Codedatenblöcke 52-x, aber keine zusätzlichen Redundanzinformationen, insbesondere keine Prüfpakete 48-x. Dadurch wird eine besondere hohe Nutzdatenrate bei vergleichsweise guter Fehlerkorrektur mit geringer Latenzzeit erreicht.

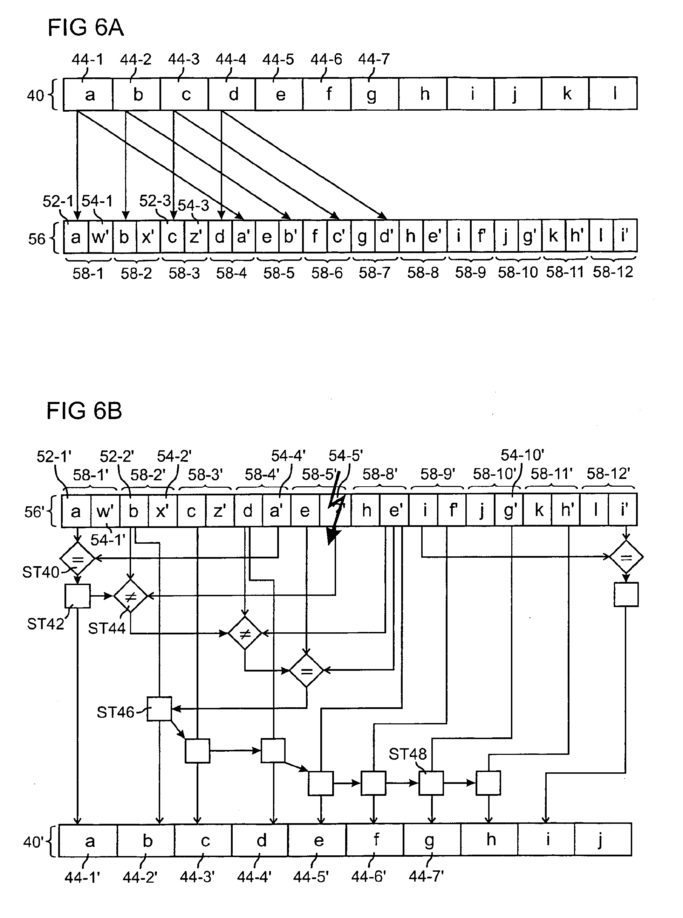

Fig. 6A und Fig. 6B veranschaulichen ein weiteres Beispiel zur Übertragung von Daten, insbesondere zum Codieren (Fig. 6A) und Decodieren (Fig. 6B) eines digitalen Datensatzes gemäß einer weiteren bevorzugten Ausführungsform der vorliegenden Erfindung. In dieser bevorzugten Ausführungsform ist das Verfahren besonders effizient für eine Anwendung zur Vorwärtsfehlerkorrektur bei der Datenübertragung insbesondere von einem ISDN-Netz in ein UMTS-Netz einsetzbar.

Im Vergleich zur ausdrücklichen Beschreibung von Fig. 1 sind hier also vorzugsweise die Rollen von Sender und Empfänger vertauscht, d.h. die mit dem Bezugszeichen 14 gekennzeichnete Vorrichtung fungiert als Sender, während die mit dem Bezugszeichen 10 gekennzeichnete Vorrichtung als Empfänger fungiert. Diese Richtung wird insbesondere auch als "downstream" oder "downlink" bezeichnet. Wie in Fig. 6A veranschaulicht, wird dabei möglichen Fehlern in der Datenübertragung durch eine doppelte Sendung des gleichen Signals begegnet.

Dazu geht das in Fig. 6A dargestellte bevorzugte Codierverfahren wiederum von einem zu übertragenden digitalen Datensatz 40 aus. Dieser wird in eine Vielzahl von Informationsdatenblöcke 44-x ("a", "b", "c", ...) mit einer vorzugsweise konstanten Datenblockgröße von beispielsweise jeweils 40 Byte unterteilt. In der bevorzugten Ausführungsform von Fig. 6A werden die Informationsdatenblöcke 44-x unmittelbar als Codedatenblöcke 52-x für das weitere Codierverfahren verwendet und es wird zur Erzeugung einer Transferdatensequenz 56 zu jedem Codedatenblock 52-x ("a", "b", "c", ...) ein korrespondierendes Codeblockduplikat 54-x ("a' ", "b'", "c'", ...) erstellt. Insbesondere wird die Transferdatensequenz 56 derart erzeugt, dass darin logisch und/oder zeitlich unmittelbar hinter bzw. nach jedem Codedatenblock 52-x ein Codeblockduplikat 54-x eines anderen Codedatenblocks angeordnet ist. Zur weiteren Erklärung soll die Kombination aus einem Codedatenblock 52-x und dem sich direkt anschließenden Codeblockduplikat 54-x als Codetransferblock 58-x (58-1, 58-2, ...) bezeichnet werden. Die Transferdatensequenz 56 setzt sich somit vorzugsweise aus einer Vielzahl von Codetransferblöcken 58-x zusammen.

Dabei gibt es im Wesentlichen zu jedem Codetransferblock 58-x (z.B. dem durch die Inhalte "d" und "a'" gebildeten Codetransferblock "d) | a' ", entspricht Codetransferblock 58-4) einen vorderen korrespondierenden Codetransferblock 58-x (z.B. den durch die Inhalte "a" und "w'" gebildeten Codetransferblock "a w' ", entspricht Codetransferblock 58-1) derart, dass das Codeblockduplikat "a' " des jeweiligen Codetransferblocks inhaltsgleich oder identisch ist zum Codedatenblock "a" des vorderen korrespondierenden Codetransferblocks. Entsprechend gibt es im Wesentlichen zu jedem Codetransferblock 58-x (z.B. dem durch die Inhalte "d" und "a' " gebildeten Codetransferblock "d) |a' ") einen hinteren korrespondierenden Codetransferblock 58-x (z.B. den durch die Inhalte "g" und "d'" gebildeten Codetransferblock "g | d' ", entspricht Codetransferblock 58-7) derart, dass der Codedatenblock "d" des jeweiligen Codetransferblocks inhaltsgleich oder identisch ist zum Codeblockduplikat "d' " des hinteren korrespondierenden Codetransferblocks.

Der Beginn korrespondierender Codetransferblöcke ist vorzugsweise um eine vorbestimmte bzw. festgelegte Duplikatverschiebung bzw. Duplikatverzögerung voneinander entfernt. In der in Fig. 6A dargestellten bevorzugten Ausführungsform entspricht die Duplikatverschiebung der Länge von 3 Codetransferblöcken bzw. der Länge von 6 Codedatenblöcken. Die Duplikatverschiebung legt damit auch den Abstand der Codeblockduplikate 54-x (z.B. "a'") vom jeweils entsprechenden Codedatenblock 52-x (z.B. "a") in der Transferdatensequenz 56 fest. Je größer der Abstand zwischen einem Codedatenblock und dem entsprechenden Codeblockduplikat in der Transferdatensequenz 56 ist, desto zuverlässiger können eventuelle Blockfehler mit großen fehlenden Blöcken korrigiert werden. Allerdings ist damit auch immer eine größere Latenzzeit verbunden. Besonders bevorzugt werden die Codeblockduplikate 54-x in einem Abstand von 320 Byte bzw. 2560 Bit vom jeweiligen Codedatenblock 52-x in der Transferdatensequenz 56 positioniert, d.h. der Wert der Duplikatverschiebung beträgt in einer bevorzugten Ausführungsform somit 320 Byte bzw. 2560 Bit. In einer Umgebung der Größe der Duplikatverschiebung zum vorderen und hinteren Ende der Transferdatensequenz 56 (also am Beginn und des Ende der Datenübertragung) gilt die oben ausgeführte bevorzugte Anordnung korrespondierender Codetransferblöcke möglicherweise nicht, weshalb dort diese Anordnung als "im Wesentlichen" für alle Transferdatenblöcke beschrieben wurde.

Fig. 6B veranschaulicht eine bevorzugte Ausführungsform für ein Decodierverfahren gemäß einem weiteren Aspekt der Erfindung, welches vorzugsweise in Verbindung mit den Codierverfahren gemäß Fig. 6A zu verwenden ist. Dabei wird eine durch die Übertragung verfälschte Transferdatensequenz 56' empfangen. Wie im Vergleich zur ursprünglich gesendeten Transferdatensequenz 56 von Fig. 6A zu erkennen ist, fehlen im empfangenen Datensatz 56' von Fig. 6B die Blöcke b', f, c', g, und d' zumindest teilweise. Insbesondere ist bei der Übertragung eine Datensequenz der Länge von 2 Codetransferblöcken 58-x' bzw. 4 Codedatenblöcken 52-x' bzw. Codeblockduplikaten 54-x' verloren gegangen. Wegen der doppelten Sendung der Dateninhalte kann aber bei ausreichendem Abstand also bei ausreichend großer Duplikatverschiebung (vorzugsweise größer oder zumindest nicht kleiner als der größtmögliche fehlende Block) das ursprüngliche Signal reproduziert werden.

In einem Schritt ST40 wird der Codedatenblock "a" eines ersten Codetransferblocks "a | w' " mit dem Codeblockduplikat "a' " eines zweiten Codetransferblocks "d | a' " verglichen, der in der empfangenen Transferdatensequenz 56' um die vorgegebene Duplikatverschiebung weiter hinten bzw. später beginnt als der erste Codetransferblock "a | w' ". Die ermittelte Übereinstimmung der beiden Datenblöcke bestätigt dass der zweite Codetransferblock 58-4' dem hinteren korrespondierenden Codetransferblock des ersten Codetransferblocks 58-1' entspricht, dass also insbesondere kein Fehlerblock zwischen den beiden Codetransferblöcken verloren gegangen ist. Der übereinstimmende Inhalt "a" der beiden verglichenen Datenblöcke wird somit in einem Schritt ST42 als Informationsdatenblock 44-1' ("a") einem Informationsdatensatz 40' zugeordnet.

Vorzugsweise werden nacheinander die Codetransferblöcke der Transferdatensequenz 56' auf diese Weise mit entsprechenden zweiten Codetransferblöcken verglichen. Insbesondere wird in einem Schritt ST44 der Codedatenblock "b" eines weiteren ersten Codetransferblocks "b | x' " (58-2') mit dem Codeblockduplikat "b' " eines weiteren zweiten Codetransferblocks "e | ?" (58-5') verglichen, der in der empfangenen Transferdatensequenz 56' um die vorgegebene Duplikatverschiebung weiter hinten bzw. später beginnt als der erste Codetransferblock "b | x' " (58-2'). Da im Bereich des zweiten empfangenen Codetransferblocks "e | ?" (58-5') während der Übertragung der oben beschriebene Datenverlust aufgetreten ist, stimmen die beiden verglichenen Datenblöcke nicht überein. Es wird also davon ausgegangen, dass zumindest ein Fehlerblock der Länge mindestens eines Codetransferblocks verloren gegangen ist.

Im vorliegenden Beispiel ist durch den Übertragungsfehler sogar ein Fehlerblock der Länge von 2 Codetransferblöcken verloren gegangen. Um dennoch die darin enthaltenen Daten für die Erstellung des Informationsdatensatzes 40' wiederzugewinnen, wird der Codedatenblock "b", dessen Duplikat verloren gegangen ist, aus dem ersten Codetransferblock 58-2' als Informationsdatenblock 44-2' und das Codeblockduplikat "g"' eines dritten Codetransferblocks "j | g' " (58-10') als weiterer Informationsdatenblock 44-7' ermittelt, wobei der dritte Codetransferblock "j | g' " (58-10') in der empfangenen Transferdatensequenz 56' um die vorgegebene Duplikatverschiebung weiter hinten bzw. später beginnt als der zweite Codetransferblock "e | ?" (58-10'). Die ermittelten Informationsdatenblöcke "b" bzw. "g" werden entsprechend in den Schritten ST46 bzw. ST48 zum Informationsdatensatz 40' hinzugefügt. Die weiteren, insbesondere dazwischen liegenden Informationsdatenblöcke "c", "d", "e", "f", usw. werden in analoger Weise, wie beispielhaft in Fig. 6B dargestellt, ermittelt und dem Informationsdatensatz 40' in der korrekten Reihenfolge zugeordnet.

Dieses Codierverfahren eignet sich besonders gut für eine Vorwärtsfehlerkorrektur, wenn die Fehlercharakteristik der Übertragung von Blockfehlern, insbesondere mit fehlenden Teilen, dominiert wird, deren Blockgröße in einem begrenzten Bereich variiert, vorzugsweise um nicht mehr als eine Faktor 20, noch mehr bevorzugt um nicht mehr als einen Faktor 10 noch mehr bevorzugt um nicht mehr als einen Faktor 5. In der Decodierung kann, durch Vergleich der bei korrekter Übertragung gleichen Blöcke, erkannt werden, zwischen welchen Blöcken und in welcher Größe ein eventueller Fehler aufgetreten ist. Insbesondere für Fehler die zusammenhängende Datenblöcke betreffen, deren Größe nicht größer ist als der Abstand zwischen einem Datenblock und dessen Duplikat ist. Damit können sehr viele Fehler bei sehr geringer Rechenzeit und großer Coderate komplett behoben werden. Insbesondere ist keine schnelle und teure Hardware für die Decodierung notwendig. Diese erfindungsgemäße Codierung bietet insbesondere bei einer Übertragung von einem ISDN-Netz (13) in ein UMTS-Netz (12) eine wesentliche Verbesserung insbesondere bei der Übertragung von Audiodaten.

Durch die vorliegende Erfindung ist es insbesondere in jeder ihrer bevorzugten Ausführungsformen sehr effizient möglich, insbesondere mobile Reportagen mit der in der Branche gewohnten ISDN-Übertragungsgüte (bezüglich Fehler und Latenzzeit) auszuführen. Das ist gegenüber bisher üblichen mobilen Paketnetzanbindungen mit großer Latenzzeit ein deutlicher Wettbewerbsvorteil.

### Bezugszeichenliste

- 10: Sender
- 11: Sendeeinrichtung
- 12: UMTS-Netz
- 13: ISDN-Netz
- 14: Empfänger
- 15: Empfangseinrichtung
- 20: Informationsdatensatz
- 22-x: Informationsdatenpakete vor der Übertragung
- 22-x': Informationsdatenpakete nach der Übertragung
- 24-x: Redundanzdatenpakete vor der Übertragung
- 24-x': Redundanzdatenpakete nach der Übertragung
- 25-x: Codedatenpakete vor der Übertragung
- 25-x': Codedatenpakete nach der Übertragung
- 26: Referenzdatenblock vor der Übertragung
- 26': Referenzdatenblock nach der Übertragung
- 28: Codedatenblock vor der Übertragung
- 28': Codedatenblock nach der Übertragung
- 30: Transferdatenblock vor der Übertragung
- 30': Transferdatenblock nach der Übertragung
- 32-x: Transferdatenabschnitte
- 34: Übertragungskanal
- 36: Fehlerblock
- 40: Datensatz, Informationsdatensatz vor der Übertragung
- 40': Datensatz, Informationsdatensatz nach der Übertragung
- 42-x: Informationsdatenpakete vor der Übertragung
- 42-x': Informationsdatenpakete nach der Übertragung
- 44-x: Informationsdatenblöcke vor der Übertragung
- 44-x': Informationsdatenblöcke nach der Übertragung
- 46-x: Codedatenpakete vor der Übertragung
- 46-x': Codedatenpakete nach der Übertragung
- 48-x: Prüfpakete vor der Übertragung
- 48-x': Prüfpakete nach der Übertragung
- 50-x: Codepaketduplikate vor der Übertragung
- 50-x': Codepaketduplikate nach der Übertragung
- 52-x: Codedatenblöcke vor der Übertragung
- 52-x': Codedatenblöcke nach der Übertragung
- 54-x: Codeblockduplikate vor der Übertragung
- 54-x': Codeblockduplikate nach der Übertragung
- 56: Transferdatensequenz vor der Übertragung
- 56': Transferdatensequenz nach der Übertragung
- 58-x: Codetransferblöcke vor der Übertragung
- 58-x': Codetransferblöcke nach der Übertragung

## Patentansprüche

1. Codierverfahren zum Codieren eines digitalen Datensatzes (20), wobei das Verfahren umfasst:
- Unterteilen des Datensatzes (20) in eine Vielzahl von Informationsdatenpaketen (22-x), wobei jedes Informationsdatenpaket (22-x) eine Vielzahl von Datenelementen umfasst;
- Generieren eines Redundanzdatenpakets (24-x) zu jedem Informationsdatenpaket (22-x) derart, dass das Redundanzdatenpaket (24-x) zumindest ein von den Datenelementen des jeweiligen Informationsdatenpakets (22-x) abhängiges Datenelement enthält;
- Zusammenfassen einer Vielzahl von Informationsdatenpaketen (22-x) mit dem jeweils dazu generierten Redundanzdatenpaket (24-x) und eines Referenzdatenblocks (26) zu einem Codedatenblock (28), wobei der Referenzdatenblock (26) vordefinierte Datenelemente enthält; und
- Umsortieren einer Vielzahl von Datenelementen innerhalb des Codedatenblocks (28) gemäß einer Codiersortiervorschrift, um einen Transferdatenblock (30) zu erhalten.

2. Codierverfahren nach Anspruch 1, wobei das Unterteilen des Datensatzes (20) in eine Vielzahl von Informationsdatenpaketen (22-x) derart ausgeführt wird, dass jedes Informationsdatenpaket (22-x) aus einer Anzahl an Datenelementen besteht, die einem vorgegebenen Wert einer Informationspaketgröße PS entspricht, wobei das Generieren eines Redundanzdatenpakets (24-x) zu jedem Informationsdatenpaket (22-x)) derart ausgeführt wird, dass jedes Redundanzdatenpaket (24-x) aus einer Anzahl an Datenelementen besteht, die einem vorgegebenen Wert einer Redundanzpaketgröße *RS* entspricht, und wobei das Zusammenfassen einer Vielzahl von Informationsdatenpaketen (22-x) mit dem jeweils dazu generierten Redundanzdatenpaket (24-x) und eines Referenzdatenblocks (26) zu einem Codedatenblock (28) derart ausgeführt wird, dass der Codedatenblock (28) aus einer Anzahl an Datenelementen besteht, die einem ganzzahligen Vielfachen eines vorgegebenen Wertes einer Fehlerblockgröße ES entspricht, wobei der Codedatenblock (28) aus einer Anzahl an Datenelementen besteht, die einem Produkt aus dem Wert der Fehlerblockgröße ES und dem Wert einer Codepaketgröße *DS* entspricht, wobei sich der Wert der Codepaketgröße *DS* aus der Summe der Werte der Informationspaketgröße PS und der Redundanzpaketgröße RS ergibt.

3. Codierverfahren nach Anspruch 2, wobei das Umsortieren der Vielzahl von Datenelementen innerhalb des Codedatenblocks (28) einen Interleaving-Prozess mit einer vorgegebenen Interleaving-Rate *N* und einer Interleaving-Blocklänge, die der Anzahl an Datenelementen im Codedatenblock (28) entspricht, umfasst, und wobei die Interleaving-Rate N mit dem Wert der Codepaketgröße *DS* übereinstimmt.

4. Decodierverfahren zum Decodieren eines übertragenen digitalen Datensatzes, umfassend:
- Erfassen zumindest eines Transferdatenblocks (30') aus dem übertragenen Datensatz, wobei der Transferdatenblock (30') eine Vielzahl von Datenelementen umfasst;
- Ermitteln eines Codedatenblocks (28') durch Umsortieren einer Vielzahl von Datenelementen innerhalb des erfassten Transferdatenblocks (30') gemäß einer Decodiersortiervorschrift;
- Identifizieren eines Referenzdatenblocks (26') und einer Vielzahl von Codedatenpaketen (25-x') im Codedatenblock (28'), wobei jedes Codedatenpaket (25-x') ein Informationsdatenpaket (22-x') und ein Redundanzdatenpaket (24-x') umfasst;
- Ermitteln zumindest eines fehlerhaften Datenelements in zumindest einem fehlerhaften Informationsdatenpaket (22-x') aus einer Abweichung zumindest eines Datenelements des Referenzdatenblocks (26') von einem vordefinierten Wert; und
- Korrigieren des Übertragungsfehlers mittels des dem fehlerhaften Informationsdatenpaket (22-x') zugeordneten Redundanzdatenpakets (24-x').

5. Decodierverfahren nach Anspruch 4, wobei das Ermitteln zumindest eines fehlerhaften Datenelements in zumindest einem fehlerhaften Informationsdatenpaket (22-x') umfasst:
- Ermitteln eines von einem vordefinierten Wert abweichenden Datenelements des Referenzdatenblocks (24-x');
- Bestimmen eines Datenfehlerblocks (36) als zusammenhängender Abschnitt des Transferdatenblocks (30'), welcher das abweichende Datenelement des Referenzdatenblocks (26') umfasst; und
- Ermitteln zumindest eines zu dem bestimmten Datenfehlerblock (36) gehörigen, in einem fehlerhaften Informationsdatenpaket (22-x') enthaltenen Datenelements als das zumindest eine fehlerhafte Datenelement:

6. Verfahren zum Übertragen eines digitalen Datensatzes umfassend:
- ein Codierverfahren gemäß einem der Ansprüche 1 bis 3 zum Generieren eines Transferdatensatzes (30) aus dem zu übertragenden Datensatz (20);
- ein Übertragen des Transferdatensatzes (30, 30') über einen digitalen Kanal (12, 13, 34); und
- ein Decodierverfahren gemäß einem der Ansprüche 4 oder 5.

7. Verfahren gemäß Anspruch 6, wobei das Übertragen des Transferdatensatzes (30, 30') über einen digitalen Kanal (12, 13, 34) ein Übertragen des Transferdatensatzes von einem UMTS-Netz (12) in ein ISDN-Netz (13) umfasst.

8. Codierverfahren zum Codieren eines digitalen Datensatzes (40), wobei das Verfahren umfasst:
- Generieren einer Vielzahl von Codedatenblöcken (52-x) aus dem Datensatz (40); und
- Erzeugen einer Transferdatensequenz (56) aus der Vielzahl von Codedatenblöcken (52-x) derart, dass die Transferdatensequenz (56) zu jedem Codedatenblock (52-x) ein dazu identisches Codeblockduplikat (54-x) umfasst.

9. Codierverfahren nach Anspruch 8, wobei das Generieren einer Vielzahl von Codedatenblöcken (52-x) aus dem Datensatz (40) für jeden Codedatenblock (52-x) ein Generieren einer Vielzahl von Codedatenpaketen (46-x) aus dem Datensatz (40) und ein Zusammenfassen der Vielzahl von Codedatenpaketen (46-x) zu dem Codedatenblock (52-x) umfasst, und wobei das Generieren einer Vielzahl von Codedatenpaketen (46-x) aus dem Datensatz (40) umfasst:
- Unterteilen des Datensatzes (40) in eine Vielzahl von Informationsdatenpaketen (42-x); und
- Generieren jeweils eines Codedatenpakets (46-x) aus jedem der Vielzahl von Informationsdatenpaketen (42-x) derart, dass jedes Codedatenpaket (46-x) vom jeweiligen Informationsdatenpaket (42-x) abhängige Redundanzinformation (48-x) umfasst.

10. Decodierverfahren zum Decodieren eines übertragenen digitalen Datensatzes, wobei das Verfahren umfasst:
- Erfassen einer Transferdatensequenz (56') aus dem übertragenen Datensatz, wobei die Transferdatensequenz (56') eine Vielzahl von Codedatenpaketen (46-x') und eine Vielzahl von Codepaketduplikaten (50-x') umfasst;
- Ermitteln zumindest eines ersten Codedatenpakets (46-1'; 46-2') und zumindest eines dazu korrespondierenden Codepaketduplikats (50-1'; 50-2') als zweites Codedatenpaket in der erfassten Transferdatensequenz (56');
- Überprüfen einer Konsistenz zumindest eines der beiden ermittelten Codedatenpakete (46-1', 50-1'; 46-2', 50-2');
- in Abhängigkeit davon, ob die Konsistenz des zumindest einen überprüften Codedatenpakets (46-1'; 46-2') festgestellt wurde:
-- Ermitteln eines Informationsdatenpakets (42-1') aus dem zumindest einen überprüften Codedatenpaket (46-1'), falls dessen Konsistenz festgestellt wurde;
-- Ermitteln eines Informationsdatenpakets (42-2') aus dem anderen der beiden ermittelten Codedatenpakete (50-2'), falls die Konsistenz des zumindest einen überprüften Codedatenpakets (46-2') nicht festgestellt wurde; und
- Zuordnen des ermittelten Informationsdatenpakets (42-1'; 42-2') zu einem Informationsdatensatz (40').

11. Codierverfahren nach Anspruch 8, wobei die Transferdatensequenz (56) derart erzeugt wird, dass darin unmittelbar nach jedem Codedatenblock (52-x) ein Codeblockduplikat (54-x) eines anderen Codedatenblocks (52-x) derart angeordnet ist, dass jedes Codeblockduplikat (54-x) vom zugehörigen Codedatenblock (52-x) um eine vorgegebene Duplikatverschiebung entfernt ist, deren Länge einem ganzzahligen Vielfachen der Länge eines Codedatenblocks (52-x) entspricht.

12. Decodierverfahren zum Decodieren eines übertragenen digitalen Datensatzes, wobei das Verfahren umfasst:
- Erfassen einer Transferdatensequenz (56') aus dem übertragenen Datensatz, wobei die Transferdatensequenz (56') eine Vielzahl von Codetransferblöcken (58-x') derart umfasst, dass jeder Codetransferblock (58-x') einen Codedatenblock (52-x') und ein Codeblockduplikat (54-x') umfasst;
- Vergleichen des Codedatenblocks (52-1'; 52-2') eines ersten Codetransferblocks (58-1'; 58-2') mit dem Codeblockduplikat (54-4'; 54-5') eines zweiten Codetransferblocks (58-4'; 58-5'), wobei der Beginn des zweiten Codetransferblocks (58-4'; 58-5') in der erfassten Transferdatensequenz (56') um eine vorbestimmte Duplikatverschiebung vom Beginn des ersten Codetransferblocks (58-1'; 58-2') entfernt ist;
- in Abhängigkeit davon, ob im Schritt des Vergleichens im Wesentlichen eine Übereinstimmung des Codedatenblocks (52-1'; 52-2') des ersten Codetransferblocks (58-1'; 58-2') mit dem Codeblockduplikat (54-4'; 54-5') des zweiten Codetransferblocks (58-4'; 58-5') festgestellt wurde:
-- Ermitteln eines Informationsdatenblocks (44-1') aus dem Codedatenblock (52-1') des ersten Codetransferblocks (58-1') und/oder aus dem Codeblockduplikat (54-4') des zweiten Codetransferblocks (58-4'), falls im Schritt des Vergleichens im Wesentlichen eine Übereinstimmung festgestellt wurde; oder
-- Ermitteln eines Informationsdatenblocks (44-2') aus dem Codedatenblock (52-2') des ersten Codetransferblocks (58-2') und Ermitteln eines weiteren Informationsdatenblocks (44-7') aus dem Codeblockduplikat (54-10') eines dritten Codetransferblocks (58-10'), wobei der Beginn des dritten Codetransferblocks (58-10') in der erfassten Transferdatensequenz (56') um die vorbestimmte Duplikatverschiebung vom Beginn des zweiten Codetransferblocks (58-5') entfernt ist, falls im Schritt des Vergleichens im Wesentlichen keine Übereinstimmung festgestellt wurde; und
- Zuordnen der ermittelten Informationsdatenblöcke (44-1'; 44-2', 44-7') zu einem Informationsdatensatz (40').

13. Sender zum Senden eines digitalen Datensatzes, umfassend:
- eine Codiereinrichtung zum Codieren des Datensatzes, wobei die Codiereinrichtung ausgelegt ist, Verfahrensschritte eines Codierverfahrens gemäß einem der Ansprüche 1 bis 3, 8, 9 oder 11 auszuführen; und
- eine Sendeeinrichtung zum Senden des erstellten Transferdatenblocks (30) bzw. der erstellten Transferdatensequenz (56) insbesondere in ein UMTS-Netz oder ein ISDN-Netz.

14. Empfänger (14) zum Empfangen eines digitalen Datensatzes, welcher insbesondere von einem Sender (10) gemäß Anspruch 21 oder 22 gesendet wurde, umfassend:
- eine Empfangseinrichtung (15) zum Empfangen des Datensatzes insbesondere aus einem ISDN-Netz (13) oder einem UMTS-Netz; und
- eine Decodiereinrichtung zum Decodieren des empfangenen Datensatzes, wobei die Decodiereinrichtung ausgelegt ist, Verfahrensschritte eines Decodierverfahrens gemäß einem der Ansprüche 4, 5, 10 oder 12 auszuführen.

15. Computerprogrammprodukt mit Programmcode, der, wenn er auf einem Computersystem geladen ist, das System veranlasst, einen oder mehrere Schritte gemäß einem Verfahren nach einem der Ansprüche 1 bis 12 auszuführen.
